(19) Europäisches Patentamt
European Patent Office
Office européen des brevets

(11) **EP 2 996 116 B1**

(12) **FASCICULE DE BREVET EUROPEEN**

(45) Date de publication et mention
de la délivrance du brevet:
**20.11.2019 Bulletin 2019/47**

(51) Int Cl.:
**G11C 13/00** *(2006.01)* **G11C 7/14** *(2006.01)*

(21) Numéro de dépôt: **15184326.5**

(22) Date de dépôt: **08.09.2015**

(54) **DISPOSITIF ET PROCÉDÉ D'ÉCRITURE DE DONNÉES DANS UNE MÉMOIRE RÉSISTIVE**

VORRICHTUNG UND VERFAHREN ZUM SCHREIBEN VON DATEN IN EINEN RESISTIVEN SPEICHER

DEVICE AND METHOD FOR WRITING DATA IN A RESISTIVE MEMORY

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR

(30) Priorité: **09.09.2014 FR 1458426**

(43) Date de publication de la demande:
**16.03.2016 Bulletin 2016/11**

(73) Titulaire: **COMMISSARIAT À L'ÉNERGIE ATOMIQUE ET AUX ÉNERGIES ALTERNATIVES**
**75015 Paris (FR)**

(72) Inventeurs:
• **HARRAND, Michel**
**38120 SAINT EGREVE (FR)**

• **VIANELLO, Elisa**
**38000 GRENOBLE (FR)**
• **THOMAS, Olivier**
**38420 REVEL (FR)**
• **GIRAUD, Bastien**
**38340 VOREPPE (FR)**

(74) Mandataire: **Cabinet Beaumont**
**4, Place Robert Schuman**
**B.P. 1529**
**38025 Grenoble Cedex 1 (FR)**

(56) Documents cités:
US-A1- 2007 091 667    US-A1- 2010 103 726
US-A1- 2010 271 861    US-A1- 2013 235 651
US-A1- 2013 250 657

## Description

<u>Domaine</u>

La présente demande concerne un dispositif et un procédé d'écriture de données dans une mémoire résistive.

<u>Exposé de l'art antérieur</u>

Les mémoires résistives sont des mémoires non volatiles comprenant des cellules mémoires ayant chacune au moins un élément résistif pouvant présenter au moins deux valeurs différentes de résistance, par exemple une valeur faible, notée Ron, et une valeur élevée, notée Roff. A titre d'exemple, l'élément résistif peut comprendre un matériau isolant électriquement, une information étant stockée dans l'élément résistif par la présence ou l'absence d'un filament conducteur continu dans le matériau isolant électriquement. Lorsque le filament conducteur est présent, la résistance Ron de l'élément résistif est faible tandis que lorsque le filament est rompu ou est absent, la résistance Roff de l'élément résistif est élevée. Le passage de la résistance de l'élément résistif d'une cellule mémoire de Ron à Roff et inversement est appelé commutation de la cellule mémoire.

On appelle opération d'écriture dans une cellule mémoire le fait de faire passer la résistance de l'élément résistif de la cellule mémoire de Roff à Ron. Une opération d'écriture correspond à la formation du filament conducteur dans l'élément résistif de la cellule mémoire. Ceci peut être obtenu en appliquant une tension déterminée pendant une durée déterminée entre une première borne et une deuxième borne de la cellule mémoire. On appelle opération d'effacement d'une cellule mémoire le fait de faire passer la résistance de l'élément résistif de la cellule mémoire de Ron à Roff. Une opération d'effacement correspond à la rupture du filament de l'élément résistif de la cellule mémoire. Pour une cellule mémoire bipolaire, ceci peut être obtenu en appliquant une tension déterminée pendant une durée déterminée entre la deuxième borne et la première borne de la cellule mémoire, c'est-à-dire avec une polarité inversée par rapport à l'opération d'écriture. Pour une cellule mémoire unipolaire, ceci peut être obtenu en appliquant une tension déterminée ayant une amplitude différente de la tension appliquée pendant l'opération d'écriture. Une opération d'initialisation doit généralement être prévue avant la première opération d'écriture pour former le premier filament en appliquant, entre les première et deuxième bornes, une tension plus importante que celle appliquée au cours d'une opération d'écriture. L'écriture de données dans une mémoire résistive correspond donc à la réalisation d'opérations d'écriture et/ou d'effacement de cellules mémoires de la mémoire résistive.

Un inconvénient des mémoires résistives est que les résistances Ron et Roff obtenues après une opération d'écriture ou une opération d'effacement présentent une variabilité élevée d'une cellule mémoire à l'autre. De plus, pour une même cellule mémoire, la résistance Ron ou Roff peut varier pour deux opérations d'écriture ou d'effacement successives. De ce fait, la détermination de la tension d'écriture ou d'effacement et de la durée d'application de cette tension est difficile. En effet, si la tension d'écriture ou d'effacement est trop faible et/ou si la durée d'application de cette tension est trop courte, certaines cellules mémoires peuvent ne pas commuter. Toutefois, si la tension d'écriture ou d'effacement est trop élevée et/ou si la durée d'application de cette tension est trop longue, certaines cellules mémoires peuvent se détériorer, ce qui entraîne une réduction de la durée de vie de ces cellules mémoires.

Les documents US 2010/103726, US 2010/271861, US 2013/235651 et US 2013/250657 décrivent des dispositifs et des procédés d'écriture de données dans une mémoire résistive.

<u>Résumé</u>

La présente invention est définie par l'objet des revendications indépendantes 1 et 8. D'autres modes de réalisation préférés sont définis par les revendications dépendantes.

Un objet d'un mode de réalisation est de pallier tout ou partie des inconvénients des dispositifs d'écriture et d'effacement d'une mémoire résistive décrits précédemment.

Un autre objet d'un mode de réalisation est d'augmenter la robustesse de la mémoire résistive, notamment de réduire la dispersion des résistances Ron et Roff des cellules mémoires de la mémoire résistive.

Un autre objet d'un mode de réalisation est d'augmenter la fiabilité de la mémoire résistive, c'est-à-dire d'augmenter l'endurance des cellules mémoires et de limiter la durée d'application aux cellules mémoires de tensions et de courants excessifs lors des opérations de lecture et d'écriture.

Un autre objet d'un mode de réalisation est d'améliorer l'efficacité énergétique de la mémoire résistive, c'est-à-dire de réduire la consommation énergétique de la mémoire résistive tout en appliquant des conditions suffisantes pour que les opérations de lecture et d'écriture se déroulent de façon convenable.

Ainsi, un mode de réalisation prévoit une mémoire résistive comprenant des éléments résistifs, la résistance de chaque élément résistif pouvant alterner entre une valeur haute dans une première plage de valeurs et une valeur basse dans une deuxième plage de valeurs strictement inférieure à la valeur haute, la mémoire comprenant, en outre, un dispositif de basculement de la résistance d'au moins un élément résistif sélectionné parmi les éléments résistifs entre les valeurs haute et basse, le dispositif comprenant un premier circuit adapté à appliquer une tension croissante aux bornes de l'élément résistif sélectionné alors que l'élément résistif sélectionné est à la valeur haute ou à la valeur basse, un deuxième circuit adapté à détecter le basculement de la résistance de l'élément résistif sélectionné et un troisième circuit adapté à interrompre le courant traversant l'élément résistif sélectionné à la détection du basculement.

Selon un mode de réalisation, le dispositif comprend un quatrième circuit de fourniture d'une première tension croissante, le deuxième circuit étant adapté à comparer la première tension avec une deuxième tension qui varie en fonction de la résistance de l'élément résistif sélectionné.

Selon un mode de réalisation, la deuxième tension est proportionnelle à la première tension avec un facteur de proportionnalité qui varie en fonction de la résistance de l'élément résistif sélectionné.

Selon un mode de réalisation, le deuxième circuit est adapté à détecter que la différence entre la première tension et la deuxième tension change de signe.

Selon un mode de réalisation, la mémoire comprend un cinquième circuit de fourniture d'une troisième tension croissante et un diviseur de tension comprenant en série au moins un composant résistif et l'élément résistif sélectionné, la troisième tension étant appliquée entre les bornes du diviseur de tension, la deuxième tension étant mesurée à un noeud du diviseur de tension entre le composant résistif et l'élément résistif sélectionné.

Selon un mode de réalisation, le quatrième circuit comprend des éléments résistifs supplémentaires montés en série et en parallèle.

Selon un mode de réalisation, le deuxième circuit comprend un comparateur recevant la première tension et la deuxième tension et fournissant un signal binaire qui dépend du signe de la différence entre la première tension et la deuxième tension.

Selon un mode de réalisation, le diviseur de tension comprend, en outre, un interrupteur commandé par le signal binaire ou un signal dérivé du signal binaire.

Un mode de réalisation prévoit également un procédé de commande d'une mémoire résistive comprenant des éléments résistifs, la résistance de chaque élément résistif pouvant alterner entre une valeur haute dans une première plage de valeurs et une valeur basse dans une deuxième plage de valeurs strictement inférieure à la valeur haute, pour le basculement de la résistance d'au moins un élément résistif sélectionné parmi les éléments résistifs entre les valeurs haute et basse, le procédé comprenant les étapes suivantes :

appliquer une tension croissante aux bornes de l'élément résistif sélectionné alors que l'élément résistif sélectionné est à la valeur haute ou à la valeur basse ;
détecter le basculement de la résistance de l'élément résistif sélectionné ; et
interrompre le courant traversant l'élément résistif sélectionné à la détection du basculement.

Selon un mode de réalisation, le procédé comprend, en outre, les étapes suivantes :

fournir une première tension croissante ; et
comparer la première tension avec une deuxième tension qui varie en fonction de la résistance de l'élément résistif sélectionné.

Selon un mode de réalisation, la deuxième tension est proportionnelle à la première tension avec un facteur de proportionnalité qui varie en fonction de la résistance de l'élément résistif sélectionné.

Selon un mode de réalisation, le procédé comprend, en outre, la détection que la différence entre la première tension et la deuxième tension change de signe.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est un schéma électrique d'un mode de réalisation d'un dispositif d'effacement d'une mémoire résistive ;
la figure 2 représente des chronogrammes de signaux mis en oeuvre par le dispositif de la figure 1 lors d'une opération d'effacement ;
les figures 3 à 6 sont des schémas électriques de modes de réalisation de parties du dispositif d'effacement de la figure 1 ;
les figures 7 et 8 sont des schémas électriques partiels d'autres modes de réalisation d'un dispositif d'effacement d'une mémoire résistive ;
la figure 9 est un schéma électrique d'un mode de réalisation d'un dispositif d'écriture dans une mémoire résistive ;

la figure 10 représente des chronogrammes de signaux mis en oeuvre par le dispositif de la figure 9 lors d'une opération d'écriture ;
la figure 11 est un schéma électrique d'un autre mode de réalisation d'un dispositif d'écriture dans une cellule mémoire d'une mémoire résistive ;
les figures 12 et 13 sont des schémas électriques de modes de réalisation d'un dispositif d'effacement d'une cellule mémoire d'une mémoire résistive ;
les figures 14 à 16 sont des schémas électriques de modes de réalisation d'un dispositif d'écriture de plusieurs cellules mémoires d'une mémoire résistive ;
la figure 17 est un schéma électrique d'un mode de réalisation d'un dispositif d'écriture et d'effacement de plusieurs cellules mémoires d'une mémoire résistive ; et
la figure 18 est un schéma électrique plus détaillé d'un mode de réalisation d'un dispositif d'écriture et d'effacement de cellules mémoires d'une mémoire résistive.

Description détaillée

Par souci de clarté, de mêmes éléments ont été désignés par de mêmes références aux différentes figures. Dans la suite de la description, les expressions "sensiblement", "environ" et "approximativement" signifient "à 10 % près".

Dans la suite de la description, un signal binaire est un signal qui alterne entre un premier état constant, par exemple un état bas noté "0", et un deuxième état constant, par exemple un état haut noté "1". En pratique, les signaux binaires peuvent correspondre à des tensions ou à des courants qui peuvent ne pas être parfaitement constants à l'état haut ou bas. Les états haut et bas de signaux binaires d'un même circuit électronique peuvent être différents.

Selon un mode de réalisation, une opération d'écriture dans une cellule mémoire d'une mémoire résistive et/ou d'effacement de la cellule mémoire est réalisée de la façon suivante :

- application d'une tension ou d'un courant croissant aux bornes de la cellule mémoire ;
- détection de la commutation de la cellule mémoire ; et
- coupure automatique du courant traversant la cellule mémoire après la détection.

Pour chaque cellule mémoire, la commutation de la cellule mémoire a lieu lorsque la tension appliquée à ses bornes atteint la tension nécessaire à sa commutation. La tension de commutation peut donc être différente d'une cellule mémoire à l'autre. La durée de vie des cellules mémoires est, de façon avantageuse, augmentée puisque chaque cellule mémoire n'est pas soumise, plus longtemps que nécessaire, à la tension ou au courant permettant sa commutation. En outre, la consommation de la mémoire résistive est réduite puisque le courant alimentant chaque cellule mémoire est interrompu dès que la cellule mémoire a commuté.

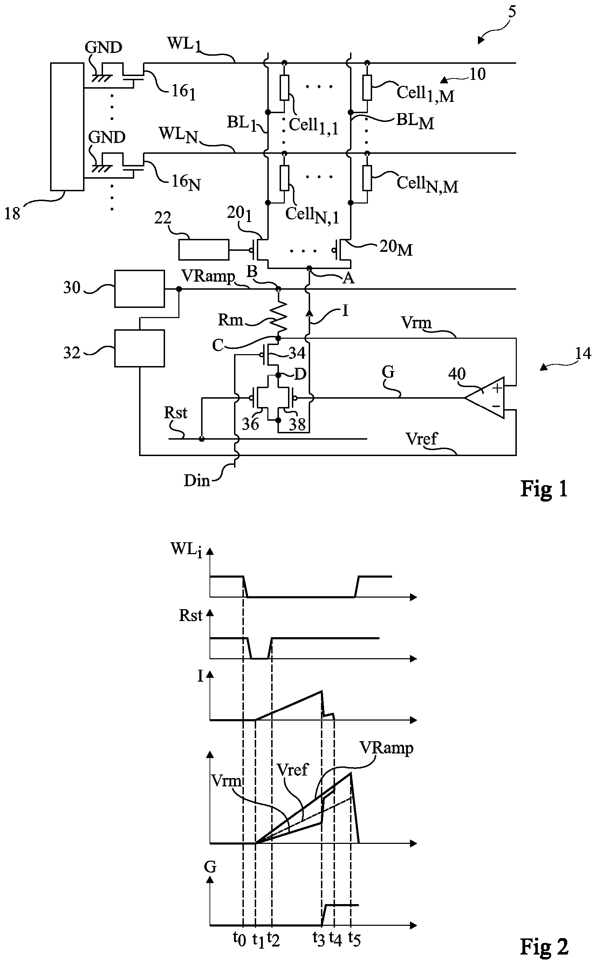

La figure 1 représente un mode de réalisation d'une mémoire résistive 5 comprenant une matrice 10 de cellules mémoires $Cell_{i,j}$, par exemple sur N rangées et M colonnes, où N et M sont des nombres entiers supérieurs à 2 et où i est un nombre entier qui varie de 1 à N et j est un nombre entier qui varie de 1 à M. La mémoire 5 comprend, en outre, un dispositif 14 d'effacement des cellules mémoires $Cell_{i,j}$.

Chaque cellule mémoire $Cell_{i,j}$ comprend des première et deuxième bornes. Pour chaque rangée de la matrice 10, les premières bornes des cellules mémoires $Cell_{i,j}$ de la rangée sont reliées à une ligne de mots $WL_i$. Pour chaque colonne de la matrice 10, les deuxièmes bornes des cellules mémoires $Cell_{i,j}$ de la colonne sont reliées à une ligne de bits $BL_j$. Chaque ligne de mot $WL_i$, i variant de 1 à N, est reliée à une source d'un potentiel de référence bas, par exemple la masse GND, par l'intermédiaire d'un interrupteur $16_i$. Les interrupteurs $16_i$ sont commandés par un module 18 de sélection de lignes de mots. A titre d'exemple, chaque interrupteur $16_i$ correspond à un transistor à effet de champ à grille métal-oxyde, ou transistor MOS, par exemple à canal N, dont le drain est relié à la ligne de mots $WL_i$, dont la source est reliée à la masse GND et dont la grille est commandée par le module 18. Chaque ligne de bits $BL_j$, j variant de 1 à M, est reliée à un interrupteur $20_j$. Les interrupteurs $20_j$ sont commandés par un module 22 de sélection de lignes de bits. A titre d'exemple, chaque interrupteur $20_j$ correspond à un transistor MOS, par exemple à canal P, dont le drain est relié à la ligne de bits $BL_j$, dont la source est reliée à un noeud A et dont la grille est commandée par le module 22.

A titre d'exemple, chaque cellule mémoire $Cell_{i,j}$ peut comprendre un élément résistif, dans lequel peut être formé un filament conducteur, en série avec un composant non linéaire. Selon un autre exemple, chaque cellule mémoire $Cell_{i,j}$ peut comprendre un élément résistif en série avec un transistor MOS. Dans ce cas, la grille du transistor MOS peut être reliée à la ligne de mots $W_i$, l'une des bornes de la cellule mémoire $Cell_{i,j}$ étant reliée à la ligne de bits $BL_j$ et l'autre borne de la cellule mémoire $Cell_{i,j}$ étant reliée à une source d'un potentiel variable.

Le dispositif d'effacement 14 comprend un circuit 30 de fourniture d'une tension VRamp croissante à un noeud B et un circuit 32 recevant la tension VRamp et fournissant une tension de référence Vref croissante et inférieure à la tension VRamp. A titre d'exemple, le circuit 30 est adapté à fournir une rampe de tension, c'est-à-dire que la tension VRamp est une fonction croissant de façon linéaire en fonction du temps. A titre de variante, la dérivée première par rapport au temps de la tension VRamp diminue dans le temps. A titre d'exemple, la tension VRamp comprend successivement une première rampe et une deuxième rampe, la dérivée première par rapport au temps de la tension VRamp pour la deuxième rampe étant inférieure strictement à la dérivée première par rapport au temps de la tension VRamp pour la première rampe.

Selon un mode de réalisation, la tension Vref est proportionnelle à la tension VRamp avec un rapport de proportionnalité strictement inférieur à 1.

Le dispositif d'effacement 14 comprend une résistance Rm entre le noeud B et un noeud C. La résistance Rm peut être formée par une piste de silicium polycristallin. On appelle Vrm la tension entre le noeud C et la masse GND. Un interrupteur 34 commandé par un signal binaire Din est prévu entre le noeud C et un noeud D. Deux interrupteurs 36 et 38, montés en parallèle, sont prévus entre les noeuds D et A. L'interrupteur 36 est commandé par un signal binaire Rst et l'interrupteur 38 est commandé par un signal binaire G. A titre d'exemple, chaque interrupteur 34, 36, 38 est fermé lorsque le signal de commande associé est dans un premier état, par exemple à l'état bas, et est ouvert lorsque le signal de commande associé est dans un deuxième état, par exemple à l'état haut. Selon un mode de réalisation, chaque interrupteur 34, 36, 38 correspond à un transistor MOS à canal P dont la grille est commandée par le signal de commande associé.

Le dispositif d'effacement 14 comprend un amplificateur opérationnel 40, monté en comparateur, dont l'entrée non inverseuse (+) est reliée au noeud C et reçoit la tension Vrm et dont l'entrée inverseuse (-) est reliée au circuit 32 et reçoit la tension Vref. Le comparateur 40 fournit le signal G. A titre d'exemple, le signal G est à "0" lorsque la tension Vrm est inférieure strictement à la tension Vref et est à "1" lorsque la tension Vrm est supérieure strictement à la tension Vref.

Lorsqu'une cellule mémoire $Cell_{i,j}$ est sélectionnée pour une opération d'effacement, cette cellule mémoire $Cell_{i,j}$ et la résistance Rm forment un pont diviseur de tension. La tension Vrm est donnée par la relation (1) suivante :

$$Vrm = \frac{RCell}{RCell + Rm} VRamp \qquad (1)$$

où Rcell est la résistance de la cellule mémoire sélectionnée $Cell_{i,j}$ et est égale à Ron ou Roff.

La résistance Rm est choisie de façon que la tension Vrm soit suffisamment grande pour être mesurable et pas trop élevée pour ne pas gêner les opérations d'écriture ou d'effacement de la cellule mémoire ou imposer une tension Vramp trop élevée. A titre d'exemple, la résistance Rm peut être sensiblement égale à Ron/10. Ensuite, la tension Vref est choisie de sorte que, lorsque la résistance de l'élément résistif de la cellule mémoire $Cell_{i,j}$ sélectionnée est égale à Roff, la tension Vrm est inférieure strictement à la tension Vref et, lorsque la résistance de l'élément résistif de la cellule mémoire $Cell_{i,j}$ est égale à Ron, la tension Vrm est supérieure strictement à la tension Vref.

La matrice mémoire 10 peut être divisée en plusieurs groupes de colonnes. Les colonnes de chaque groupe de colonnes peuvent être reliées à des noeuds A différents et le dispositif d'effacement 14 peut être partiellement dupliqué pour chaque groupe de colonnes. Plus précisément, la résistance Rm, les interrupteurs 34, 36, 38 et le comparateur 40 sont reproduits pour chaque groupe de colonnes et les circuits 30 et 32 peuvent être communs à tous les groupes de colonnes.

La figure 2 représente des chronogrammes de signaux mis en oeuvre par la mémoire 5 de la figure 1 lors d'une opération d'effacement. Les instants $t_0$ à $t_5$ sont des instants successifs.

A l'instant $t_0$, la cellule mémoire $Cell_{i,j}$ dans laquelle une opération d'effacement doit être réalisée est sélectionnée. Ceci est obtenu en reliant la ligne de mots $WL_i$ à la masse GND et en rendant passant le transistor 20j. En outre, le signal Rst est mis à "0", ce qui rend passant le transistor 36. Le signal Din est à "0" lorsqu'une opération d'effacement doit être réalisée dans la cellule mémoire sélectionnée. Le transistor 34 est alors passant.

A l'instant $t_1$, la tension VRamp commence à croître depuis la valeur nulle. Les tensions Vref et Vrm commencent donc à croître. En outre, un courant I commence à circuler dans la cellule mémoire $Cell_{i,j}$ sélectionnée. La résistance de l'élément résistif de la cellule mémoire $Cell_{i,j}$ étant égale à Ron, la tension Vrm est inférieure strictement à la tension Vref. Le signal G fourni par le comparateur 40 est à "0" dès que l'écart entre les tensions Vrm et Vref est suffisant. La valeur du signal G pouvant être incertaine tant que les tensions Vrm et Vref ne sont pas suffisamment différentes, le transistor 36 qui est passant permet d'assurer un chemin de conduction entre les noeuds A et D jusqu'à ce que le signal G soit de façon certaine à "0".

A l'instant $t_2$, le signal Rst passe de "0" à "1". Le transistor 36 passe à l'état bloqué.

A l'instant $t_3$, la tension appliquée sur la cellule mémoire $Cell_{i,j}$ est suffisamment élevée pour entraîner la commutation de la cellule mémoire. La résistance de l'élément résistif de la cellule mémoire $Cell_{i,j}$ passe de Ron à Roff. La tension Vrm s'élève alors au-dessus de Vref. Le courant I diminue.

A l'instant $t_4$, le signal G fourni par le comparateur 40 passe à "1". Le transistor 38 passe à l'état bloqué. Le courant I s'annule et aucune tension n'est plus appliquée à la cellule mémoire $Cell_{i,j}$.

A l'instant $t_5$, le circuit 30 interrompt la fourniture de la tension VRamp, par exemple après une durée déterminée.

A titre de variante, le transistor 36 peut ne pas être présent. Le dispositif d'effacement 14 peut alors comprendre des moyens pour assurer que le signal G est à "0" au début d'une opération d'effacement. A titre d'exemple, le dispositif d'effacement 14 peut comprendre un élément de mémorisation du type bascule (en anglais flip-flop) entre le comparateur 40 et le transistor 38.

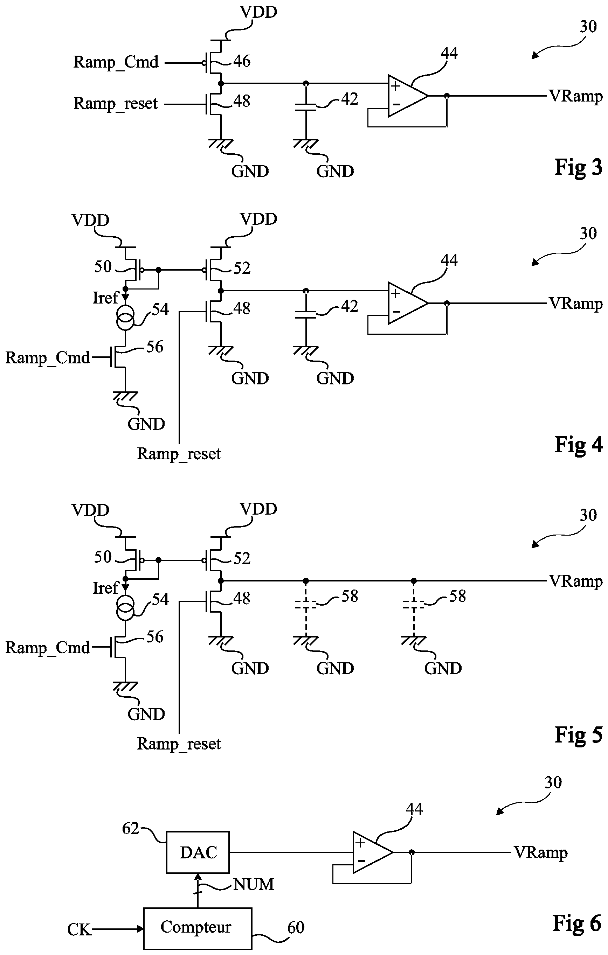

La figure 3 représente un mode de réalisation du circuit 30 de fourniture de la tension VRamp. Dans ce mode de réalisation, le circuit 30 comprend un condensateur 42 dont une électrode est reliée à la masse GND et dont l'autre électrode est reliée à l'entrée non inverseuse (+) d'un amplificateur opérationnel 44 monté en suiveur. L'entrée inverseuse (-) de l'amplificateur opérationnel 44 est reliée à la sortie de l'amplificateur opérationnel 44. L''amplificateur opérationnel 44 fournit la tension VRamp. Le circuit 30 comprend, en outre, un transistor MOS 46 à canal P et un transistor MOS 48 à canal N. La source du transistor 46 est reliée à une source d'un potentiel haut VDD. Les drains des transistors 46 et 48 sont reliés à l'entrée non inverseuse (+) de l'amplificateur opérationnel 44. La source du transistor 48 est reliée à la masse GND. La grille du transistor MOS reçoit un signal binaire Ramp_Cmd et la grille du transistor 48 reçoit un signal binaire Ramp_reset.

Le fonctionnement du circuit 30 représenté en figure 3 est le suivant. Le condensateur 42 est déchargé en rendant passant le transistor 48, le transistor 46 étant bloqué. Le transistor 48 est ensuite rendu passant et le transistor 46 est bloqué. Les propriétés de conduction du transistor 46 sont choisies pour que la charge du condensateur 42 soit progressive. La tension aux bornes du condensateur 42 correspond à la tension VRamp. L'amplificateur opérationnel 44 recopie la tension Vramp.

La figure 4 représente un autre mode de réalisation du circuit 30 de fourniture de la tension VRamp. Dans ce mode de réalisation, au lieu du transistor 46, il est prévu un miroir de courant comprenant deux transistors MOS 50 et 52 à canal P, une source de courant 54 fournissant un courant Iref et un transistor MOS 56 à canal N. Les sources des transistors 50 et 52 sont reliées à la source du potentiel VDD. Le drain du transistor 52 est relié à l'entrée non inverseuse (+) de l'amplificateur opérationnel 44. La grille du transistor 50 est reliée à la grille du transistor 52, au drain du transistor 50 et à une borne de la source de courant 54. L'autre borne de la source de courant 54 est reliée au drain du transistor 56 et la source du transistor 56 est reliée à la masse GND.

Le miroir de courant recopie le courant Iref fourni par la source de courant 54 avec un facteur multiplicatif égal au rapport entre les largeurs de grille des transistors 52 et 50. Lorsque le transistor 56 est passant et que le transistor 48 est bloqué, le condensateur 42 est chargé à courant constant avec le courant recopié par le miroir de courant. Le mode de réalisation représenté en figure 4 permet d'obtenir une rampe plus linéaire et de mieux contrôler la durée de la rampe par rapport au mode de réalisation représenté en figure 3.

La figure 5 représente un autre mode de réalisation du circuit 30 de fourniture de la tension VRamp. Par rapport au mode de réalisation représenté en figure 4, le condensateur 42 et l'amplificateur opérationnel 44 ne sont pas présents. Le rôle joué par le condensateur 42 est rempli dans le présent mode de réalisation par la capacité parasite, illustrée en figure 5 par des condensateurs 58 représentés par des tirets, de la piste conductrice qui transmet la tension VRamp.

La figure 6 représente un autre mode de réalisation du circuit 30 de fourniture de la tension VRamp. Dans ce mode de réalisation, le circuit 30 comprend un compteur 60 (Compteur) cadencé par un signal d'horloge CK et fournissant un signal numérique NUM codé sur plusieurs bits. Le signal NUM est reçu par un convertisseur numérique-analogique 62 (DAC) qui convertit le signal numérique NUM en un signal analogique fourni à l'entrée non inverseuse (+) de l'amplificateur opérationnel 44. La vitesse de croissance du signal VRamp est déterminée par la fréquence du signal d'horloge CK et le nombre de bits du signal NUM. A titre de variante, un filtre passe-bas peut être interposé entre le convertisseur numérique-analogique 62 et l'amplificateur opérationnel 44 pour lisser la tension VRamp. En pratique, la fonction de filtre passe-bas peut être réalisée par l'amplificateur opérationnel 44 et la capacité parasite de la piste conductrice transmettant la tension VRamp.

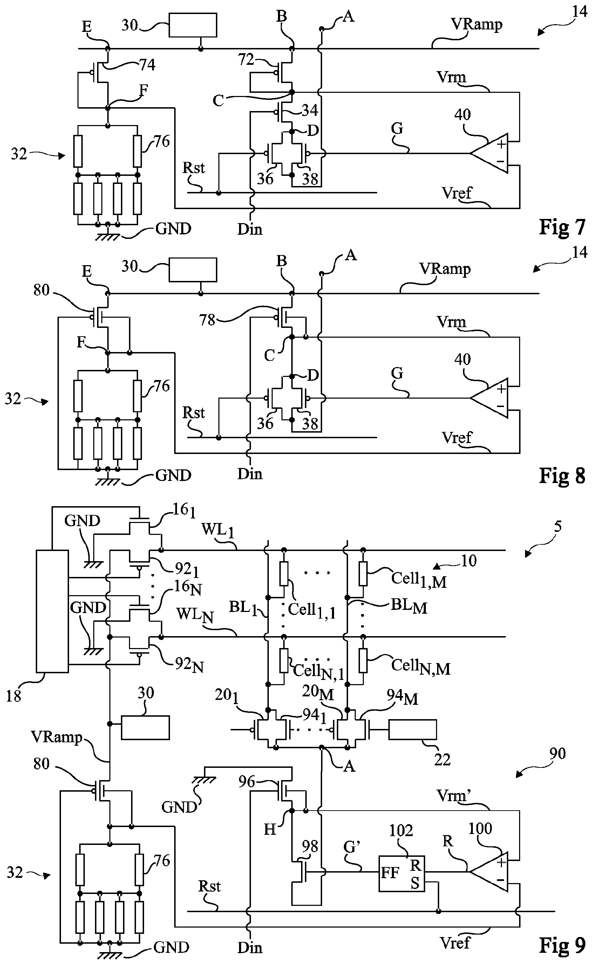

La figure 7 représente un mode de réalisation plus détaillé du dispositif d'effacement 14 dans lequel la résistance Rm est réalisée par un transistor MOS 72 à canal P monté en diode. La source du transistor 72 est reliée au noeud B, le drain et la grille du transistor 72 étant reliés au noeud C.

Le circuit 32 de fourniture de la tension VRamp comprend un transistor MOS 74 à canal P, monté en diode, entre un noeud E et un noeud F. Le noeud E reçoit la tension VRamp. La source du transistor 74 est reliée au noeud E, le drain et la grille du transistor 74 étant reliés au noeud F. De préférence, le transistor 74 est identique au transistor 72. Lorsque la résistance Rm est formée par une piste de silicium polycristallin, le transistor MOS 74 est de préférence remplacé par une résistance identique en silicium polycristallin.

Le circuit 32 comprend, en outre, entre le noeud F et la masse GND, un ensemble de cellules mémoires 76 montées en série et en parallèle de façon que la résistance équivalente Req de l'ensemble des cellules mémoires 76 est inférieure strictement à Roff. A titre d'exemple, un ensemble de six cellules mémoires 72 ayant chacune une résistance Roff est représenté en figure 7 et les cellules mémoires de cet ensemble sont agencées de façon que la résistance équivalente Req de l'ensemble des cellules mémoires 76 est égale à 3/4*Roff. A titre de variante, des cellules mémoires 76 ayant chacune une résistance Ron peuvent être utilisées. Le circuit 32 peut, en outre, comprendre en série avec l'ensemble de cellules mémoires 76 une résistance représentative des résistances parasites sur la ligne de bits BL$_j$ et

la ligne de mots WL$_i$ lors de la sélection de la cellule mémoire Cell$_{i,j}$. Comme les cellules mémoires 76 sont en série, chaque cellule mémoire 76 ne voit pas une tension suffisamment élevée pour commuter. Le circuit 32 joue le rôle d'un diviseur de tension. La tension Vref est donnée par la relation (2) suivante :

$$\mathrm{Vref} = \frac{\mathrm{Req}}{\mathrm{Req+Rm}} \mathrm{VRamp} \qquad (2)$$

La figure 8 représente un autre mode de réalisation plus détaillé du dispositif d'effacement 14 dans lequel la résistance Rm et le transistor 34 représentés en figure 1 sont remplacés par un transistor MOS 78 à canal P dont la source est reliée au noeud B, dont le drain est relié au noeud D, dont la grille reçoit le signal Din et dont le substrat est relié au drain. Ceci signifie que, dans le cas où le substrat du transistor 78 correspond à une région dopée de type N dans laquelle sont formées des régions dopées de type P correspondant au drain et à la source du transistor 78, le drain et le substrat sont amenés sensiblement au même potentiel.

Le mode de réalisation représenté en figure 8 permet, de façon avantageuse, de supprimer l'un des transistors MOS 72 et 34 par rapport au mode de réalisation représenté en figure 7. Comme le substrat et le drain du transistor 78 sont reliés ensemble, la tension de seuil du transistor 78 est d'autant plus faible que la tension Vrm est basse. De ce fait, on évite de perdre la tension de seuil du transistor 72 monté en diode dans la tension VRamp. Une tension VRamp moins élevée peut ainsi être utilisée, ce qui permet de réduire la consommation électrique du dispositif d'effacement 14.

De préférence, le circuit 32 de fourniture de la tension Vref, représenté en figure 8, comprend, à la place du transistor 74 représenté en figure 7, un transistor MOS 80 à canal P identique au transistor 78, dont la source est reliée au noeud E, dont le drain est relié au noeud F, dont la grille est reliée à la masse GND et dont le substrat est relié au drain.

La figure 9 représente un mode de réalisation de la mémoire 5 dans lequel la mémoire 5 comprend un dispositif 90 d'écriture des cellules mémoires Cell$_{i,j}$, c'est-à-dire adapté à faire passer la résistance de l'élément résistif d'une cellule mémoire Cell$_{i,j}$ de Roff à Ron. Les éléments communs avec le dispositif d'effacement 14 représenté en figure 1 sont désignés par les mêmes références.

Chaque ligne de mot WL$_i$, i variant de 1 à N, est reliée au circuit 30 de fourniture de la tension VRamp par l'intermédiaire d'un interrupteur 92$_i$. Les interrupteurs 92$_i$ sont commandés par le module 18 de sélection de lignes de mots. A titre d'exemple, chaque interrupteur 92 correspond à un transistor MOS à canal P dont le drain est relié à la ligne de mots WL$_i$, dont la source est reliée au circuit 30 et dont la grille est commandée par le module 18. Chaque ligne de bits BL$_j$, j variant de 1 à M, est reliée au noeud A par l'intermédiaire d'un interrupteur 94$_j$. Les interrupteurs 94 sont commandés par le module 22 de sélection de lignes de bits. A titre d'exemple, chaque interrupteur 94$_j$ correspond à un transistor MOS à canal N dont le drain est relié à la ligne de bits BL$_j$, dont la source est reliée au noeud A et dont la grille est commandée par le module 22.

Le dispositif d'écriture 90 comprend un transistor MOS 96 à canal N dont la source est reliée à la masse GND, dont le drain est relié à un noeud H, dont la grille reçoit le signal Din et dont le substrat est relié au drain. On appelle Rm' la résistance équivalente du transistor 96. On appelle Vrm' la tension entre le noeud H et la masse GND. Un interrupteur 98 est monté entre les noeuds H et A. L'interrupteur 98 est commandé par un signal binaire G'. A titre d'exemple, l'interrupteur 98 correspond à un transistor MOS à canal N, dont la source est reliée au noeud H, dont le drain est relié au noeud A et dont la grille est commandée par le signal G'.

Le dispositif d'écriture 90 comprend, en outre, un amplificateur opérationnel 100, monté en comparateur, dont l'entrée non inverseuse (+) est reliée au noeud H et reçoit la tension Vrm' et dont l'entrée inverseuse (-) est reliée au circuit 32 et reçoit la tension Vref. Le comparateur 100 fournit un signal binaire R. A titre d'exemple, le signal R est à "0" lorsque la tension Vrm' est inférieure strictement à la tension Vref et est à "1" lorsque la tension Vrm' est supérieure strictement à la tension Vref.

Le dispositif d'écriture 90 comprend, en outre, un élément de mémorisation 102 de type bascule, qui fournit le signal G'. La bascule 102 comprend une entrée de commande S recevant le signal binaire Rst et une entrée R de remise à zéro recevant le signal R. De façon classique, lorsque le signal Rst sur l'entrée de commande S passe de "0" à "1", la sortie G' de la bascule 102 est mise à "1". Lorsque le signal R sur l'entrée R de mise à zéro passe de "0" à "1", la sortie G' de la bascule 102 passe à "0". Lorsque le signal R sur l'entrée R de mise à zéro passe de "1" à "0" ou lorsque le signal Rst sur l'entrée S de commande passe de "1" à "0", la sortie G' de la bascule 102 n'est pas modifiée.

Lorsqu'une cellule mémoire Cell$_{i,j}$ est sélectionnée pour une opération d'écriture, la cellule mémoire Cell$_{i,j}$ et la résistance Rm' équivalente du transistor MOS 96 forment un pont diviseur de tension. La tension Vrm' est donnée par la relation (3) suivante :

$$\mathrm{Vrm'} = \frac{\mathrm{Rm'}}{\mathrm{RCell+Rm'}} \mathrm{VRamp} \qquad (3)$$

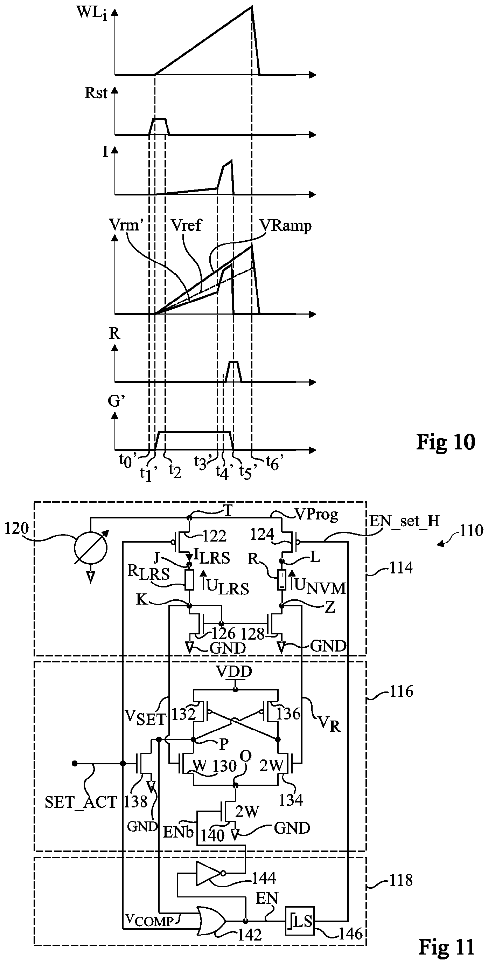

La figure 10 représente des chronogrammes de signaux mis en oeuvre par la mémoire 5 de la figure 9 lors d'une opération d'écriture. Les instants $t'_0$ à $t'_6$ sont des instants successifs.

A l'instant $t'_0$, le signal Rst passe à "1", ce qui entraîne la mise à "1" du signal G' en sortie de la bascule 102. Le transistor 98 devient donc passant. Le signal Din est à "1" lorsqu'une opération d'écriture doit être réalisée dans la cellule mémoire sélectionnée. Le transistor 96 est alors passant.

A l'instant $t'_1$, la tension VRamp commence à croître depuis la valeur nulle. Les tensions Vref et Vrm' commencent donc à croître. En outre, un courant I commence à circuler dans la cellule mémoire $Cell_{i,j}$ sélectionnée. La résistance de la cellule mémoire $Cell_{i,j}$ étant égale à Roff, la tension Vrm' est inférieure strictement à la tension Vref. Le signal R fourni par le comparateur 100 est à "0". Toutefois, la sortie G' de la bascule reste à "1".

A l'instant $t'_2$, le signal Rst passe de "1" à "0". Le signal G' en sortie de la bascule 102 n'est toutefois pas modifié.

A l'instant $t'_3$, la tension appliquée sur la cellule mémoire $Cell_{i,j}$ est suffisamment élevée pour entraîner la commutation de la cellule mémoire. La résistance de l'élément résistif de la cellule mémoire $Cell_{i,j}$ passe de Roff à Ron. La tension Vrm' s'élève alors au-dessus de Vref. Le courant I diminue et le signal R fourni par le comparateur 100 passe à "1".

A l'instant $t'_5$, la bascule 102 recevant le signal R met le signal G' à "0". L'interrupteur 98 passe à l'état bloqué. Le courant I s'annule et aucune tension n'est plus appliquée à la cellule mémoire $Cell_{i,j}$. Au cours de sa chute, la tension Vrm' passe au-dessous de la tension Vref et le signal R' passe à "0". Toutefois, le signal G' est maintenu à "0".

A l'instant $t'_6$, le circuit 30 interrompt la fourniture de la tension VRamp.

Dans le mode de réalisation représenté en figure 9, pour réaliser une opération d'écriture, la ligne de bits $BL_j$ reliée à la cellule mémoire $Cell_{i,j}$ sélectionnée est mise à la masse GND et la ligne de mots $WL_i$ reliée à la cellule mémoire $Cell_{i,j}$ sélectionnée reçoit la tension VRamp. Ceci permet avantageusement d'utiliser le même circuit 30 pour une opération d'écriture et une opération d'effacement. Selon un autre mode de réalisation, pour réaliser une opération d'effacement, la ligne de mots $WL_i$ reliée à la cellule mémoire $Cell_{i,j}$ sélectionnée peut être mise au potentiel haut VDD et la ligne de bits $BL_j$ reliée à la cellule mémoire $Cell_{i,j}$ sélectionnée peut recevoir une tension continument décroissante, par exemple de VDD à 0 V.

Selon un mode de réalisation, la mémoire 5 peut comprendre le dispositif d'effacement 14 représenté en figure 1 et le dispositif d'écriture 90 représenté en figure 9. Dans ce cas, les circuits 30 et 32 peuvent être communs aux dispositifs d'écriture et d'effacement. En outre, dans le cas où le dispositif d'effacement 14 comprend également une bascule, la bascule 102 et l'amplificateur opérationnel 100 peuvent être communs au dispositif d'effacement 14 et au dispositif d'écriture 90.

Selon un autre mode de réalisation, une opération d'écriture dans une cellule mémoire d'une mémoire résistive et/ou d'effacement de la cellule mémoire est réalisée de la façon suivante :

- circulation d'un courant dans la cellule mémoire ;
- comparaison de la tension aux bornes de la cellule mémoire avec une tension de référence ;
- détection de la commutation de la cellule mémoire à partir de la comparaison de la tension aux bornes de la cellule mémoire et de la tension de référence ; et
- coupure automatique du courant traversant la cellule mémoire après la détection.

Pour chaque cellule mémoire, la consommation de la cellule mémoire est réduite puisque le courant alimentant chaque cellule mémoire est interrompu dès que la cellule mémoire a commuté. La durée de vie de la cellule mémoire est de façon avantageuse préservée puisque la cellule mémoire n'est pas soumise à la tension de commutation plus longtemps que nécessaire. En outre, le courant traversant la cellule mémoire est interrompu lorsque la tension aux bornes de la cellule mémoire atteint une tension déterminée, c'est-à-dire lorsque la résistance de la cellule mémoire atteint une résistance déterminée. De façon avantageuse, les résistances Ron des cellules mémoires après une opération d'écriture sont sensiblement égales et les résistances Roff des cellules mémoires après une opération d'effacement sont sensiblement égales.

Le principe de fonctionnement d'un dispositif d'écriture et d'un dispositif d'effacement va dans un premier temps être décrit pour une opération d'écriture ou d'effacement pour une seule cellule mémoire. L'utilisation du dispositif d'écriture et du dispositif d'effacement avec une mémoire résistive comprenant plusieurs cellules mémoires est décrite dans un second temps.

La figure 11 représente un autre mode de réalisation d'un dispositif d'écriture 110 d'un élément résistif R d'une cellule mémoire. Le dispositif d'écriture 110 comprend un circuit de programmation 114, un circuit de détection de fin d'écriture 116 et un circuit logique de contre réaction 118.

Le circuit de programmation 114 comprend un circuit 120 de fourniture d'une tension de programmation VProg à un noeud T. La tension VProg peut être une tension constante ou une tension monotone par palier, par exemple continument croissante, par exemple une rampe de tension, pendant une partie d'une opération d'écriture ou d'effacement, par exemple du début d'une opération d'écriture ou d'effacement au moins jusqu'à la commutation de la cellule mémoire, puis décroissante à la fin de l'opération d'écriture ou d'effacement. Le circuit 120 peut avoir la même structure que le circuit 30 décrit précédemment. Le circuit de programmation 114 comprend, en outre, une résistance de référence $R_{LRS}$ entre des noeuds J et K et un interrupteur 122 commandé par un signal binaire SET ACT entre le noeud T et le noeud J. L'interrupteur 122 peut correspondre à un transistor MOS à canal P dont la source est reliée au noeud T, dont le drain est relié au noeud J et dont la grille reçoit le signal SET_ACT. Selon un mode de réalisation, la résistance de référence $R_{LRS}$ est sensiblement égale au niveau de résistance Ron souhaitée pour l'élément résistif R. La résistance $R_{LRS}$ peut être réalisée par une piste de silicium polycristallin.

L'élément résistif R est placé entre des noeuds L et Z. Le circuit de programmation 114 comprend un interrupteur 124 commandé par un signal binaire EN_set_H entre le noeud T et le noeud L. L'interrupteur 124 peut correspondre à un transistor MOS à canal P dont la source est reliée au noeud T, dont le drain est relié au noeud L et dont la grille reçoit le signal EN_set_H.

Le circuit de programmation 114 comprend un miroir de courant qui reproduit le courant traversant la résistance $R_{LRS}$ dans l'élément résistif R. Le miroir de courant comprend, par exemple, un transistor MOS 126 à canal N, monté en diode, dont le drain est relié au noeud K, dont la source est reliée à la masse GND et dont la grille est reliée au drain. Le miroir de courant comprend, en outre, un transistor MOS 128 à canal N, dont le drain est relié au noeud Z, dont la source est reliée à la masse GND et dont la grille est reliée à la grille du transistor 126. On appelle $V_{SET}$ la tension entre le noeud K et la masse GND et $V_R$ la tension entre le noeud Z et la masse GND.

Le circuit de détection 116 est adapté à comparer les tensions $V_{SET}$ et $V_R$. Il comprend un transistor MOS 130 à canal N dont la source est reliée à un noeud O, dont le drain est relié à un noeud P et dont la grille est reliée au noeud K et reçoit la tension $V_{SET}$. On appelle $V_{COMP}$ la tension entre le noeud P et la masse GND. Le noeud P est relié au drain d'un transistor MOS 132 à canal P. Le circuit de détection 116 comprend, en outre, un transistor MOS 134 à canal N dont la source est reliée au noeud O, dont le drain est relié au drain d'un transistor MOS 136 à canal P et dont la grille est reliée au noeud Z et reçoit la tension $V_R$. Les sources des transistors MOS 132 et 136 sont reliées à une source du potentiel de référence haut VDD. La grille du transistor 132 est reliée au drain du transistor 136 et la grille du transistor 136 est reliée au drain du transistor 132. De préférence, la largeur de grille du transistor 134 est supérieure à la largeur de grille du transistor 130. A titre d'exemple, la largeur de grille du transistor 134 est égale au double de la largeur de grille du transistor 130.

Le circuit de détection 116 comprend, entre le noeud P et la masse GND, un interrupteur 138 commandé par le signal binaire SET_ACT. L'interrupteur 138 peut correspondre à un transistor MOS à canal N dont la source est reliée à la masse GND, dont le drain est relié au noeud P et dont la grille reçoit le signal SET_ACT. Le circuit de détection 116 comprend, en outre, entre le noeud O et la masse GND, un interrupteur 140 commandé par un signal binaire ENb. L'interrupteur 140 peut correspondre à un transistor MOS à canal N dont la source est reliée à la masse GND, dont le drain est relié au noeud O et dont la grille reçoit le signal ENb. La largeur de grille du transistor 140 peut être égale à la somme de la largeur de grille du transistor 134 et de la largeur de grille du transistor 130.

Le circuit logique 118 comprend un bloc 142 réalisant la fonction logique "OU", recevant les signaux $V_{COMP}$ et SET_ACT et fournissant un signal binaire EN. Le circuit logique 118 comprend, en outre, un bloc 144 réalisant la fonction logique "NON", recevant le signal EN et fournissant le signal ENb. Le circuit logique 118 peut, en outre, comprendre un circuit de conversion de niveau 146 recevant le signal EN et fournissant le signal EN_set_H. L'état haut du signal EN_set_H est à une tension supérieure à l'état haut du signal EN et est adapté à la commande de certains transistors MOS. A titre d'exemple, l'état haut du signal EN_set_H correspond à VProg. A titre de variante, le circuit 146 peut ne pas être présent.

Selon un mode de réalisation, le dispositif 110 peut comprendre, en outre, un convertisseur de tension recevant le signal SET_ACT et dont la sortie est reliée à la grille du transistor 138 et à la grille du transistor 122.

Le fonctionnement du dispositif d'écriture 110 est le suivant. Avant le début d'une opération d'écriture, le signal SET_ACT est à "1". Le transistor 138 est donc passant, ce qui maintient la tension $V_{COMP}$ à "0". En outre, le transistor 122 est bloqué. Aucun courant ne circule dans la résistance $R_{LRS}$. Le signal EN est à "1" et le signal ENb est à "0". Le transistor 140 est donc bloqué. Le signal EN_set_H est à "1". Le transistor 124 est donc bloqué. Aucun courant ne circule dans l'élément résistif R.

Au début d'une opération d'écriture, le signal SET_ACT est mis à "0". Le transistor 122 devient donc passant. Comme le signal $V_{COMP}$ est à "0", le signal EN passe à "0" et le signal ENb passe à "1". Le transistor 140 devient donc passant. Le signal EN_set_H passe à "0". Le transistor 124 devient donc passant. Le circuit 120 fournissant la tension de programmation VProg conduit à la circulation d'un courant $I_{LRS}$ dans la résistance $R_{LRS}$. Le courant $I_{LRS}$ est recopié par le miroir de courant et circule dans l'élément résistif R. La résistance de l'élément résistif R pouvant être supposée égale à Roff, c'est-à-dire supérieure à $R_{LRS}$, la tension $U_{NVM}$ aux bornes de l'élément résistif R est supérieure à la tension $U_{LRS}$ aux bornes de la résistance $R_{LRS}$. Comme les tensions drain-source des transistors 122 et 124 sont identiques et sensiblement nulles, la tension $V_R$ est inférieure à la tension $V_{SET}$. Le transistor 130 est donc davantage passant que le transistor 134. Le signal $V_{COMP}$ reste à "0", le transistor 136 étant passant et le transistor 132 étant bloqué.

Lorsque l'élément résistif R commute, la résistance de l'élément résistif R diminue. Lorsque la résistance de l'élément résistif R devient sensiblement égale à $R_{LRS}$, la tension $U_{NVM}$ devient sensiblement égale à la tension $U_{LRS}$ et la tension $V_R$ devient sensiblement égale à $V_{SET}$. Comme la largeur de grille du transistor 134 est supérieure à la largeur de grille du transistor 130, le transistor 134 est davantage passant que le transistor 130. Ceci entraîne un basculement de $V_{COMP}$ de "0" à "1", le transistor 132 devenant passant et le transistor 136 devenant bloqué. Le signal EN, et donc le signal EN_set_H, passent alors de "0" à "1". Le transistor 124 est bloqué, interrompant la circulation de courant dans l'élément résistif R. En outre, le signal ENb passe de "1" à "0" entraînant le blocage du transistor 140.

Selon un autre mode de réalisation, la largeur de grille du transistor 134 peut ne pas être supérieure à la largeur de grille du transistor 130. Dans ce cas, la résistance de référence $R_{LRS}$ est supérieure à la résistance Ron souhaitée. Lorsque l'élément résistif R commute, la résistance de l'élément résistif R diminue depuis Roff vers Ron. Lorsque la résistance de l'élément résistif R devient inférieure à la résistance $R_{LRS}$, la tension $U_{NVM}$ devient inférieure à la tension $U_{LRS}$ et la tension $V_R$ devient supérieure à $V_{SET}$. Le transistor 134 est davantage passant que le transistor 130. Ceci entraîne un basculement de $V_{COMP}$ de "0" à "1".

Pour chaque cellule mémoire, le courant traversant la cellule mémoire est interrompu dès que la cellule mémoire a commuté. La durée de vie de la cellule mémoire est de façon avantageuse préservée puisque la cellule mémoire n'est pas soumise, plus longtemps que nécessaire, à la tension et au courant permettant sa commutation. En outre, la consommation de la cellule mémoire lors d'une opération d'écriture est réduite. En outre, dans le présent mode de réalisation, la circulation de courant dans l'élément résistif R est interrompue après que la résistance de l'élément résistif R atteint une valeur déterminée pour laquelle le signal $V_{COMP}$ passe de "0" à "1". On commande ainsi la résistance de l'élément résistif R après la commutation.

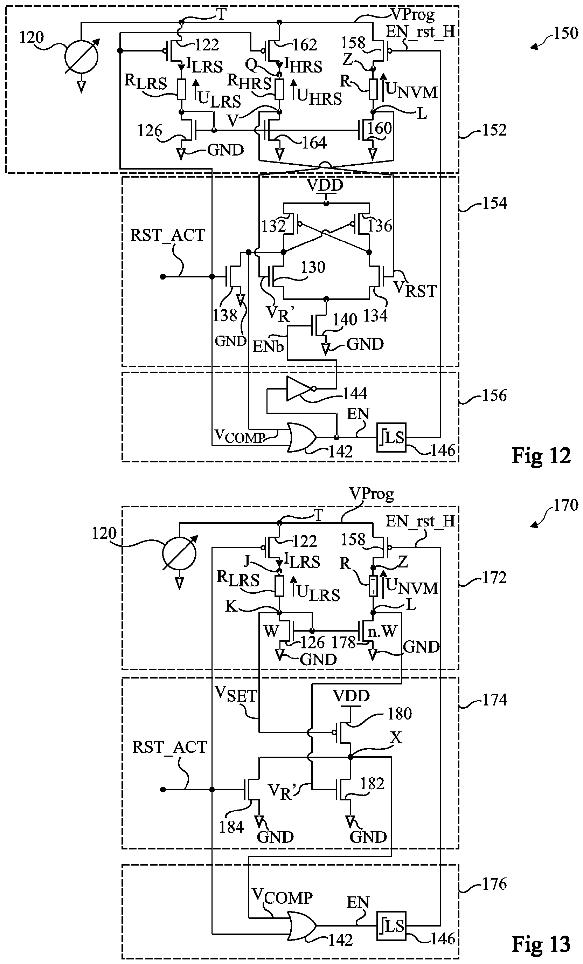

La figure 12 représente un mode de réalisation d'un dispositif d'effacement 150 d'un élément résistif R.

Le dispositif d'effacement 150 comprend un circuit de programmation 152, un circuit de détection de fin d'effacement 154 et un circuit logique de contre réaction 156. Le circuit de détection 154 peut être identique au circuit 116 décrit précédemment à la différence que le signal SET_ACT est remplacé par un signal binaire RST_ACT. Le circuit logique 156 peut être identique au circuit logique 118 décrit précédemment à la différence que le signal SET_ACT est remplacé par un signal binaire RST_ACT et que le signal EN_set_H est remplacé par un signal binaire EN_rst_H.

Le circuit de programmation 152 comprend certains éléments du circuit de programmation 114 décrit précédemment. Le circuit de programmation 152 comprend notamment le circuit 120 de fourniture de la tension VProg au noeud T. Le circuit de programmation 152 comprend un interrupteur 158 commandé par le signal binaire EN_rst_H entre le noeud T et le noeud Z. L'interrupteur 158 peut correspondre à un transistor MOS à canal P dont la source est reliée au noeud T, dont le drain est relié au noeud Z et dont la grille reçoit le signal EN_rst_H.

Le circuit de programmation 152 comprend un transistor MOS 160 à canal N, dont le drain est relié au noeud L, dont la source est reliée à la masse GND et dont la grille est reliée à la grille du transistor MOS 126. On appelle $V_R'$ la tension entre le noeud L et la masse GND.

Le circuit de programmation 152 comprend, en outre, une résistance de référence $R_{HRS}$ entre des noeuds Q et V et un interrupteur 162 commandé par le signal binaire RST_ACT entre le noeud T et le noeud Q. L'interrupteur 162 peut correspondre à un transistor MOS à canal P dont la source est reliée au noeud T, dont le drain est relié au noeud Q et dont la grille reçoit le signal RST_ACT. Dans le présent mode de réalisation, la résistance $R_{HRS}$ est sensiblement égale à la résistance Roff souhaitée pour l'élément résistif R. La résistance $R_{HRS}$ peut être réalisée par une piste de silicium polycristallin. On appelle $U_{HRS}$ la tension aux bornes de la résistance $R_{HRS}$ et $V_{RST}$ la tension entre le noeud V et la masse GND. Le circuit de programmation 152 comprend, en outre, un transistor MOS 164 à canal N dont le drain est relié au noeud V, dont la source est reliée à la masse GND et dont la grille est reliée à la grille du transistor 126. Le noeud V est relié à la grille du transistor 134 et le noeud L est relié à la grille du transistor 130.

La largeur de grille du transistor 160 peut être supérieure à la largeur de grille du transistor 126.

Le fonctionnement du dispositif d'effacement 150 est le suivant. Avant le début d'une opération d'effacement, le signal RST_ACT est à "1". Le transistor 138 est donc passant, ce qui maintient le signal $V_{COMP}$ à "0". En outre, les transistors 122 et 162 sont bloqués. Aucun courant ne circule dans les résistances $R_{LRS}$ et $R_{HRS}$. Le signal EN est à "1" et le signal ENb est à "0". Le transistor 140 est donc bloqué. Le signal EN_rst_H est à "1". Le transistor 158 est donc bloqué. Aucun courant ne circule dans l'élément résistif R.

Au début d'une opération d'effacement, le signal RST_ACT est mis à "0". Les transistors 122 et 162 deviennent donc passants. Comme le signal $V_{COMP}$ est à "0", le signal EN passe à "0" et le signal ENb passe à "1". Le transistor 140 devient donc passant. Le signal EN_rst_H passe à "0". Le transistor 158 devient donc passant. Le circuit 120 fournit la tension de programmation VProg. Celle-ci conduit à la circulation d'un courant $I_{LRS}$ dans la résistance $R_{LRS}$. Le courant $I_{LRS}$, recopié par le miroir de courant, éventuellement avec un facteur de multiplication supérieur à 1, circule dans l'élément résistif R et dans la résistance $R_{HRS}$. La résistance de l'élément résistif R étant de niveau bas, la tension $U_{NVM}$ aux bornes de l'élément résistif R est inférieure à la tension $U_{HRS}$ aux bornes de la résistance $R_{HRS}$ et la tension $V_R'$ est supérieure à la tension $V_{RST}$. Le transistor 130 est donc davantage passant que le transistor 134. Le signal $V_{COMP}$ reste donc à "0", le transistor 136 étant passant et le transistor 132 étant bloqué.

Lorsque l'élément résistif R commute, la résistance de l'élément résistif R augmente. Lorsque la tension $U_{NVM}$

devient sensiblement égale à la tension $U_{HRS}$, la tension $V_R'$ devient sensiblement égale à $V_{RST}$. Comme la largeur de grille du transistor 134 est supérieure à la largeur de grille du transistor 130, le transistor 134 est davantage passant que le transistor 130. Ceci entraîne un basculement de $V_{COMP}$ de l'état "0" à l'état "1", le transistor 132 devenant passant et le transistor 136 devenant bloqué. Le signal EN et le signal EN_rst_H passent alors de "0" à "1". Le transistor 158 est alors bloqué, interrompant la circulation de courant dans l'élément résistif R. En outre, le signal ENb passe de "1" à "0" entraînant le blocage du transistor 140.

Selon un autre mode de réalisation, la largeur de grille du transistor 134 peut ne pas être supérieure à la largeur de grille du transistor 130. Dans ce cas, la résistance de référence $R_{HRS}$ est inférieure à la résistance Roff souhaitée. Lorsque l'élément résistif R commute, la résistance de l'élément résistif R augmente de Ron vers Roff. Lorsque la résistance de l'élément résistif R devient supérieure à la résistance $R_{HRS}$, la tension $U_{NVM}$ devient supérieure à la tension $U_{\overline{HRS}}$ et la tension $V_R'$ devient inférieure à $V_{RST}$. Le transistor 134 est davantage passant que le transistor 130. Ceci entraîne un basculement de $V_{COMP}$ de "0" à "1".

Pour chaque cellule mémoire, le courant traversant la cellule mémoire est interrompu dès que la cellule mémoire a commuté. La durée de vie de la cellule mémoire est de façon avantageuse préservée puisque la cellule mémoire n'est pas soumise, plus longtemps que nécessaire, à la tension et au courant permettant sa commutation. En outre, la consommation de la cellule mémoire lors d'une opération d'effacement est réduite. En outre, dans le présent mode de réalisation, la circulation de courant dans l'élément résistif R est interrompue après que la résistance de l'élément résistif R atteint une valeur déterminée pour laquelle le signal $V_{COMP}$ passe de "0" à "1". On commande ainsi la résistance de l'élément résistif R après la commutation.

La figure 13 représente un autre mode de réalisation d'un dispositif d'effacement 170 d'un élément résistif R.

Le dispositif d'effacement 170 comprend un circuit de programmation 172, un circuit de détection de fin d'effacement 174 et un circuit logique de contre réaction 176. Le circuit de programmation 172 comprend les transistors 122 et 126 et la résistance $R_{LRS}$ du circuit 114 décrit précédemment en relation avec la figure 11. Le circuit de programmation 172 comprend, en outre, le transistor 158 du circuit 152 décrit précédemment en relation avec la figure 12. L'élément résistif R est connecté comme pour le circuit 152. Le circuit de programmation 172 comprend, en outre, un transistor MOS 178 à canal N dont la source est reliée à la masse GND, dont la grille est reliée à la grille du transistor 126 et dont le drain est relié au noeud L. La largeur de grille du transistor 178 peut être supérieure, par exemple d'un facteur n supérieur à 1, à la largeur de grille du transistor 126. Le circuit logique 176 peut comprendre le bloc logique 142 et le circuit de mise à niveau 146 du circuit logique 156 décrits précédemment.

Le circuit de détection 174 comprend un transistor MOS 180 à canal P dont la source est reliée à la source du potentiel de référence VDD, dont la grille est reliée au noeud K et reçoit la tension $V_{SET}$ et dont le drain est relié à un noeud X. Le circuit de détection 174 comprend un transistor MOS 182 à canal N dont la source est reliée à la masse GND, dont la grille est reliée au noeud L et reçoit la tension $V_R'$ et dont le drain et relié au noeud X. Le noeud X fournit le signal $V_{COMP}$ reçu par la porte logique "OU" 142. Le circuit de détection 174 comprend un transistor MOS 184 à canal N dont la source est reliée à la masse GND, dont la grille reçoit le signal RST_ACT et dont le drain est relié au noeud X.

Le fonctionnement du dispositif d'effacement 170 est le suivant. Avant le début d'une opération d'effacement, le signal RST_ACT est à "1". Le transistor 122 est donc bloqué. Aucun courant ne circule dans la résistance $R_{LRS}$. Le transistor 184 est passant et le signal $V_{COMP}$ est à "0". Le signal EN est à "1" et le signal EN_rst_H est à "1". Le transistor 158 est donc bloqué. Aucun courant ne circule dans l'élément résistif R.

Au début d'une opération d'effacement, le signal RST_ACT est mis à "0". Le transistor 122 devient donc passant et le transistor 184 est bloqué. Comme le signal $V_{COMP}$ est à "0", le signal EN et le signal EN_rst_H passent à "0". Le transistor 158 devient donc passant. Le circuit 120 fournit la tension de programmation VProg. Celle-ci conduit à la circulation d'un courant $I_{LRS}$ dans la résistance $R_{LRS}$. Le courant $I_{LRS}$ est recopié par le miroir de courant et circule dans l'élément résistif R multiplié par le facteur de multiplication n. La résistance de l'élément résistif R étant initialement de valeur Ron, la tension $U_{NVM}$ aux bornes de l'élément résistif R est de l'ordre de n fois la tension $U_{LRS}$ aux bornes de la résistance $R_{LRS}$. Les transistors 180 et 182 sont dimensionnés pour que dans cette configuration, le transistor 182 soit davantage passant que le transistor 180. Le signal $V_{COMP}$ reste donc à "0".

Lorsque l'élément résistif R commute, la résistance de l'élément résistif R augmente de Ron à Roff. La tension $U_{NVM}$ augmente et le signal $V_R'$ diminue. Le transistor 180 devient alors davantage passant que le transistor 182. Ceci entraîne un basculement de $V_{COMP}$ de "0" à "1". Le signal EN et le signal EN_rst_H passent de "0" à "1". Le transistor 158 est alors bloqué, interrompant la circulation de courant dans l'élément résistif R et donc l'opération d'effacement.

Pour chaque cellule mémoire, le courant traversant la cellule mémoire est interrompu peu après que la cellule mémoire a commuté. La durée de vie de la cellule mémoire est de façon avantageuse préservée puisque la cellule mémoire n'est pas soumise, plus longtemps que nécessaire, à la tension et au courant permettant sa commutation. En outre, la consommation de la cellule mémoire lors d'une opération d'effacement est réduite. En outre, dans le présent mode de réalisation, la circulation de courant dans l'élément résistif R est interrompue après que la résistance de l'élément résistif R atteint une valeur de résistance déterminée pour laquelle le signal $V_{COMP}$ passe de "0" à "1". On commande ainsi la résistance de l'élément résistif R après la commutation.

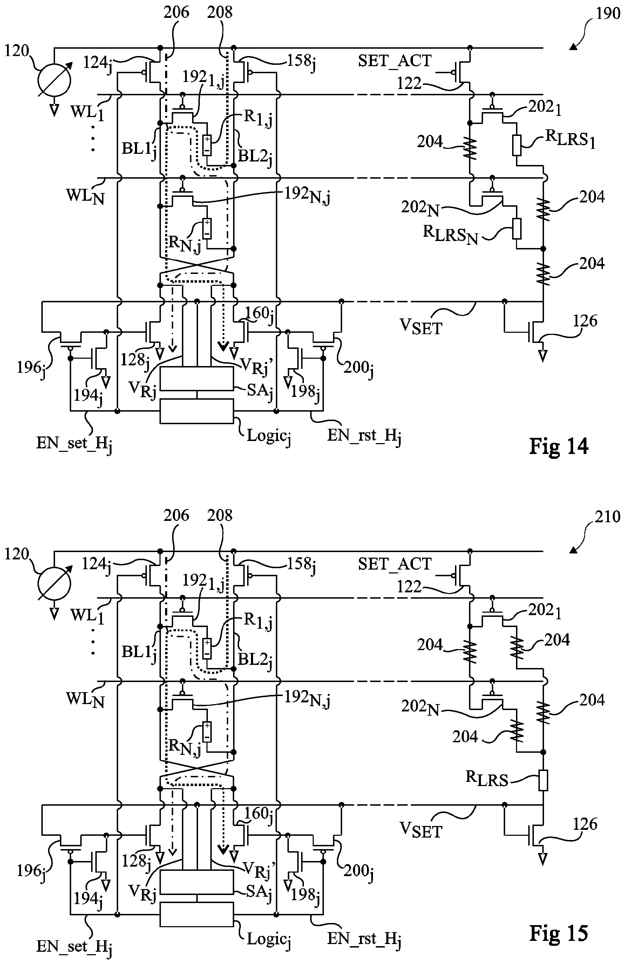

La figure 14 représente un mode de réalisation d'une mémoire 190 comprenant un dispositif d'écriture dont le fonctionnement peut être similaire à ce qui a été décrit précédemment pour le dispositif d'écriture 110 représenté en figure 11. La mémoire 190 comprend une matrice d'éléments résistifs $R_{i,j}$ disposés sur N rangées et M colonnes, où i varie de 1 à N et j varie de 1 à M. En figure 14, on a représenté les éléments résistifs de la première rangée et de la dernière rangée pour la colonne "j". En outre, les éléments de la mémoire 190 identiques aux éléments des dispositifs d'écriture ou d'effacement décrits précédemment en relation avec les figures 11 à 13 sont désignés par les mêmes références auxquelles un indice peut être ajouté pour indiquer que l'élément est répété pour chaque rangée "i" et/ou pour chaque colonne "j".

A titre d'exemple, deux éléments résistifs $R_{1,j}$ et $R_{N,j}$ de la colonne j sont représentés en figure 14. Chaque élément résistif $R_{i,j}$ comprend une première borne (+) et une deuxième borne (-). La borne (+) est reliée à la source d'un transistor MOS $192_{i,j}$ à canal P. Pour chaque rangée "i", la grille de chaque transistor $192_{i,j}$ de la rangée est reliée à une ligne de mots $WL_i$. Pour chaque colonne "j", la source de chaque transistor $192_{i,j}$ de la colonne est reliée à une première ligne de bits $BL1_j$ et la borne (-) de chaque élément résistif $R_{i,j}$ de la colonne est reliée à une deuxième ligne de bits $BL2_j$. La ligne de bits $BL1_j$ est reliée au drain du transistor $124_j$ et au drain du transistor $160_j$. La ligne de bits $BL2_j$ est reliée au drain du transistor $158_j$ et au drain du transistor $128_j$.

La mémoire 190 comprend un circuit de détection de fin d'écriture et/ou d'effacement $SA_j$ qui est relié aux lignes de bits $BL1_j$ et $BL2_j$ et à la grille du transistor 126. Le fonctionnement du circuit $SA_j$ peut être analogue à celui du circuit de détection de fin d'écriture 116 ou 174 décrit précédemment. La mémoire 190 comprend un circuit logique $Logic_j$ qui est relié au circuit $SA_j$ et qui fournit les signaux $EN\_set\_H_j$ et $EN\_rst\_H_j$. Le fonctionnement du circuit $Logic_j$ peut être analogue à celui du circuit logique 118 ou 176 décrit précédemment.

La mémoire 190 comprend, en outre, un transistor MOS $194_j$ à canal N dont la source est reliée à la masse GND, dont le drain est relié à la grille du transistor $128_j$ et dont la grille reçoit le signal $EN\_set\_H_j$. La mémoire 190 comprend, en outre, un transistor MOS $196_j$ à canal P dont la source est reliée à la grille du transistor 126, dont le drain est relié à la grille du transistor $128_j$ et dont la grille reçoit le signal $EN\_set\_H_j$. La mémoire 190 comprend, en outre, un transistor MOS $198_j$ à canal N dont la source est reliée à la masse GND, dont le drain est relié à la grille du transistor $160_j$ et dont la grille reçoit le signal $EN\_rst\_H_j$. La mémoire 190 comprend, en outre, un transistor MOS $200_j$ à canal P dont la source est reliée à la grille du transistor 126, dont le drain est relié à la grille du transistor $160_j$ et dont la grille reçoit le signal $EN\_rst\_H_j$.

Dans le mode de réalisation représenté en figure 14, une résistance de référence $R_{LRSi}$ et un transistor MOS $202_i$ à canal P sont prévus pour chaque rangée "i". La grille du transistor $202_i$ est reliée à la ligne de mots $WL_i$ et le drain du transistor $202_i$ est relié à une première borne de la résistance $R_{LRSi}$. Pour la première rangée, la source du transistor $202_1$ est reliée au drain du transistor 122. Pour les autres rangées, la source du transistor $202_i$ de la rangée est reliée à la source du transistor $202_{i-1}$ de la rangée précédente. Pour la dernière rangée, la deuxième borne de la résistance $R_{LRSN}$ est reliée au drain du transistor 126. Pour les autres rangées, la deuxième borne de la résistance $R_{LRSi}$ est reliée à la deuxième borne de la résistance $R_{LRSi+1}$ de la rangée suivante. On a représenté en figure 14 des résistances parasites 204 qui sont sensiblement réparties de façon homogène sur les pistes conductrices reliant les interrupteurs $202_i$.

Le fonctionnement de la mémoire 190 est le suivant. L'élément résistif $R_{i,j}$ dans laquelle une opération d'écriture ou d'effacement doit être réalisée est sélectionné par la mise à la masse de la ligne de mots $WL_i$ de façon que le transistor $192_{i,j}$ devienne passant, les autres lignes de mots étant maintenues au potentiel haut VDD. En outre, le transistor 122 est passant de sorte qu'un courant circule dans la résistance $R_{LRSi}$ de la même rangée que l'élément résistif $R_{i,j}$ sélectionné.

Pour une opération d'écriture dans l'élément résistif $R_{i,j}$ de la colonne "j", le signal $EN\_set\_H_j$ est mis à "0" et le signal $EN\_rst\_H_j$ est mis à "1". Le transistor $196_j$ est donc passant et le transistor $194_j$ est bloqué. Un courant peut donc circuler au travers du transistor $128_j$. Le transistor $198_j$ est passant et le transistor $200_j$ est bloqué. Le transistor $160_j$ est donc bloqué et aucun courant ne peut le traverser. De ce fait, lors de l'opération d'écriture, un courant traverse successivement le transistor $124_j$, le transistor $192_{i,j}$, l'élément résistif $R_{i,j}$, de la borne (+) vers la borne (-), et le transistor $128_j$. Le parcours du courant est représenté par une ligne 206 tiretée.

Pour une opération d'effacement dans l'élément résistif $R_{i,j}$ de la colonne "j", le signal $EN\_set\_H_j$ est mis à "1" et le signal $EN\_rst\_H_j$ est mis à "0". Le transistor $200_j$ est donc passant et le transistor $198_j$ est bloqué. Un courant peut donc circuler au travers du transistor $160_j$. Le transistor $194_j$ est passant et le transistor $196_j$ est bloqué. Le transistor $128_j$ est donc bloqué et aucun courant ne peut le traverser. De ce fait, lors de l'opération d'effacement, un courant traverse successivement le transistor $158_j$, l'élément résistif $R_{i,j}$, de la borne (-) vers la borne (+), le transistor $192_{i,j}$, et le transistor 160j. Le parcours du courant est représenté par une ligne 208 en pointillé.

L'agencement des résistances $R_{LRSi}$ fait que les résistances parasites vues par le courant $I_{LRS}$ traversant la résistance $R_{LRSi}$ sont sensiblement les mêmes quel que soit l'élément résistif $R_{i,j}$ sélectionné.

La figure 15 représente un autre mode de réalisation d'une mémoire 210. La mémoire 210 comprend l'ensemble des éléments de la mémoire 190 à la différence qu'une seule résistance $R_{LRS}$ est présente et est utilisée quel que soit l'élément résistif $R_{i,j}$ sélectionné. On a donc, de façon avantageuse, un gain en surface par rapport à la mémoire 190 et moins de variabilité sur le courant $I_{LRS}$ puisque la même résistance $R_{LRS}$ est utilisée. En outre, les résistances parasites vues par le courant $I_{LRS}$ traversant la résistance $R_{LRS}$ sont sensiblement les mêmes quel que soit l'élément résistif $R_{i,j}$ sélectionné.

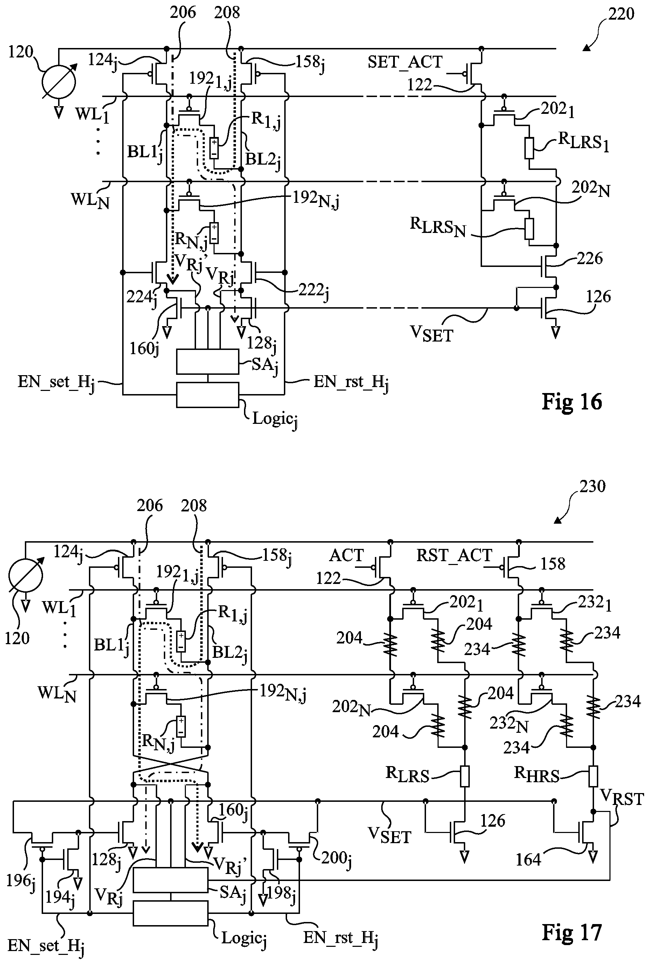

La figure 16 représente un autre mode de réalisation d'une mémoire 220. La mémoire 220 comprend l'ensemble des éléments de la mémoire 190 à la différence que les transistors $194_j$, $196_j$, $198_j$ et $200_j$ ne sont pas présents. La mémoire 220 comprend un transistor MOS $222_j$ à canal N dont la source est reliée au drain du transistor $128_j$ et au circuit $SA_j$, dont le drain est relié à la ligne $BL2_j$ et dont la grille reçoit le signal EN_rst_H$_j$. La mémoire 220 comprend un transistor MOS $224_j$ à canal N dont la source est reliée au drain du transistor $160_j$ et au circuit $SA_j$, dont le drain est relié à la ligne $BL1_j$ et dont la grille reçoit le signal EN_set_H$_j$. La mémoire 220 comprend, en outre, un transistor MOS 226 à canal N dont la source est reliée au drain du transistor 126, dont le drain est relié à une borne de chaque résistance $R_{LRSi}$ et dont la grille est reliée au drain du transistor 122.

Pour une opération d'écriture dans l'élément résistif $R_{i,j}$ de la colonne "j", le signal EN_set_H$_j$ est mis à "0" et le signal EN_rst_H$_j$ est mis à "1". Le transistor $222_j$ est donc passant et le transistor $224_j$ est bloqué. De ce fait, le courant circule comme cela est représenté par la ligne 206 tiretée. Pour une opération d'effacement dans l'élément résistif $R_{i,j}$ de la colonne "j", le signal EN_set_H$_j$ est mis à "1" et le signal EN_rst_H$_j$ est mis à "0". Le transistor $224_j$ est donc passant et le transistor $222_j$ est bloqué. De ce fait, le courant circule comme cela est représenté par la ligne 208 en pointillé.

Dans le mode de réalisation représenté en figure 16, la mémoire 220 a, de façon avantageuse, une structure simplifiée, avec un nombre réduit de transistors, par rapport à la mémoire 190.

La figure 17 représente un autre mode de réalisation d'une mémoire 230 dans lequel le dispositif d'effacement 170 décrit précédemment en relation avec la figure 13 peut être mis en oeuvre. La mémoire 230 a la même structure que la mémoire 210 représentée en figure 15. La mémoire 230 comprend, en outre, pour chaque rangée, un transistor MOS à canal P $232_i$ dont la grille est reliée à la ligne de mots $WL_i$. Pour la première rangée, la source du transistor $232_1$ est reliée au drain du transistor 158. Pour les autres rangées, la source du transistor $232_i$ de la rangée est reliée à la source du transistor $232_{i-1}$ de la rangée précédente. Pour la dernière rangée, le drain du transistor $232_N$ est relié à une borne de la résistance $R_{HRS}$. Pour les autres rangées, le drain du transistor $232_i$ de la rangée est relié au drain du transistor $232_{i+1}$ de la rangée suivante. On a représenté en figure 17 des résistances parasites 234 qui sont sensiblement réparties de façon homogène sur les pistes conductrices reliant les interrupteurs $232_i$. Bien entendu, on peut prévoir une résistance $R_{HRS}$ pour chaque rangée de manière analogue à ce qui a été décrit pour les résistances $R_{LRSi}$ en figure 16. Le circuit de détection $SA_j$ est, en outre, relié au drain du transistor 164. Le fonctionnement du circuit $SA_j$ peut être analogue à celui du circuit de détection de fin d'écriture 156 décrit précédemment.

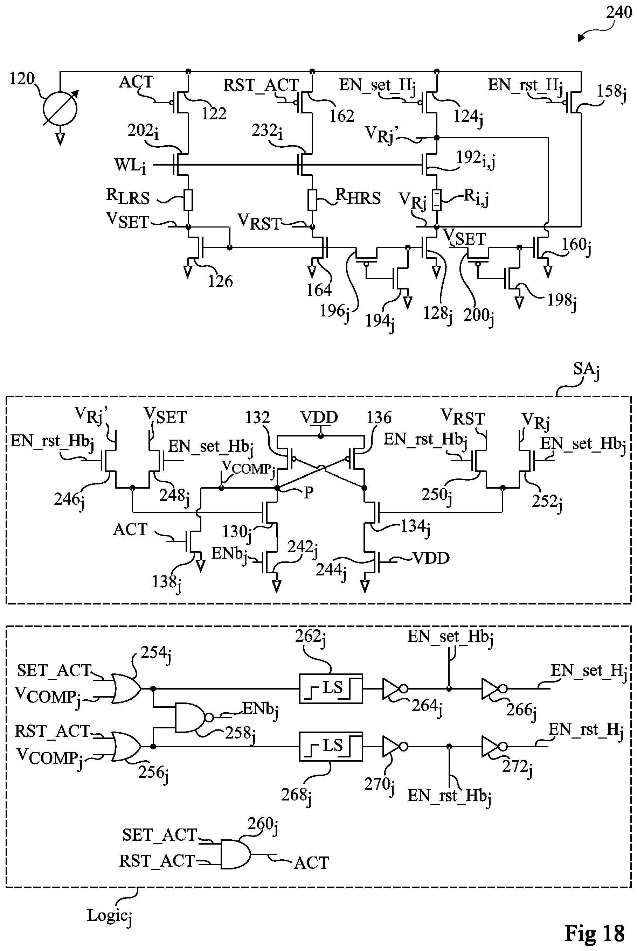

La figure 18 représente un mode de réalisation plus détaillé d'un dispositif d'écriture et d'effacement 240 adapté à être mis en oeuvre avec la mémoire 230 de la figure 17. Les éléments communs avec le dispositif d'écriture 110 représenté en figure 11 et le dispositif d'effacement 150 représenté en figure 12 sont désignés par les mêmes références auxquelles un indice peut être ajouté pour indiquer que l'élément est répété pour chaque rangée "i" et/ou pour chaque colonne "j".

La grille du transistor 122 reçoit un signal ACT et la grille du transistor 162 reçoit le signal RST_ACT.

Le circuit de détection de fin d'écriture et/ou d'effacement $SA_j$ comprend l'ensemble des éléments du circuit 154 à la différence que le transistor 140 est remplacé par deux transistors MOS $242_j$, $244j$ à canal N. Le drain du transistor $242_j$ est relié à la source du transistor 130j. La source du transistor $242_j$ est reliée à la masse GND et la grille du transistor $242_j$ reçoit le signal EN$b_j$. Le drain du transistor $244_j$ est relié à la source du transistor $134_j$. La source du transistor $244_j$ est reliée à la masse GND et la grille du transistor $244_j$ reçoit le potentiel de référence haut VDD. Le transistor $244_j$ est donc passant.

Le circuit $SA_j$ comprend, en outre, un transistor MOS $246_j$ à canal N dont le drain reçoit le signal $V_{Rj}'$ et dont la grille reçoit le signal EN_rst_Hb$_j$. Le circuit $SA_j$ comprend, en outre, un transistor MOS $248_j$ à canal N dont le drain reçoit le signal $V_{SET}$ et dont la grille reçoit le signal EN_set_Hb$_j$. Les sources des transistors $246_j$ et $248_j$ sont reliées à la grille du transistor $130_j$. Le circuit $SA_j$ comprend, en outre, un transistor MOS $250_j$ à canal N dont le drain reçoit le signal $V_{RST}$ et dont la grille reçoit le signal EN_rst_Hb$_j$. Le circuit $SA_j$ comprend, en outre, un transistor MOS $252_j$ à canal N dont le drain reçoit le signal $V_{Rj}$ et dont la grille reçoit le signal EN_set_Hb$_j$. Les sources des transistors $250_j$ et $252_j$ sont reliées à la grille du transistor $134_j$.

La commande des opérations d'écriture et de lecture est effectuée par les signaux binaires SET_ACT et RST_ACT. Le circuit logique Logicj comprend quatre blocs logiques $254_j$, $256_j$, $258_j$ et $260_j$. Le bloc $254_j$ réalise la fonction logique "OU" et reçoit les signaux SET_ACT et $V_{COMPj}$. Le bloc $256_j$ réalise la fonction logique "OU" et reçoit les signaux RST_ACT et $V_{COMPj}$. Le bloc $258_j$ réalise la fonction logique "NON ET", reçoit les sorties des blocs $254_j$ et $256_j$ et fournit le signal EN$b_j$. Le bloc $260_j$ réalise la fonction logique "ET", reçoit les signaux SET_ACT et RST_ACT et fournit le signal ACT.

Le circuit logique Logic$_j$ comprend un circuit de conversion de niveau $262_j$ recevant la sortie du bloc $254_j$. La sortie du circuit de conversion de niveau $262_j$ attaque un inverseur $264_j$ qui fournit le signal EN_set_Hb$_j$. Le signal

EN_set_Hb$_j$ attaque un inverseur 266$_j$ qui fournit le signal EN_set_H$_j$. Le circuit logique Logic$_j$ comprend un circuit de conversion de niveau 268$_j$ recevant la sortie du bloc 256$_j$. La sortie du circuit de conversion de niveau 268$_j$ attaque un inverseur 270$_j$ qui fournit le signal EN_rst_Hb$_j$. Le signal EN_rst_Hb$_j$ attaque un inverseur 272$_j$ qui fournit le signal EN_rst_H$_j$.

Les signaux SET_ACT et RST_ACT sont à "1" par défaut. Le signal ACT est donc à "1". Le transistor 138 est donc passant, ce qui maintient le signal V$_{COMPj}$ à "0". En outre, les transistors 122, 162 sont bloqués. Aucun courant ne circule dans les résistances R$_{LRS}$ et R$_{HRS}$. Le signal ENb$_j$ est à "0". Le transistor 242$_j$ est donc bloqué. Les signaux EN_set_Hb$_j$ et EN_rst_Hb$_j$ sont à "0". Les transistors 246$_j$, 248$_j$, 250$_j$ et 252$_j$ sont donc bloqués. Les signaux EN_set_H$_j$ et EN_rst_H$_j$ sont à "1", les transistors 124$_j$ et 158$_j$ sont donc bloqués. Aucun courant ne circule dans l'élément résistif R$_{i,j}$. Les signaux SET_ACT et RST_ACT sont identiques pour toutes les colonnes de la matrice.

Pour réaliser une opération d'écriture dans l'élément résistif R$_{i,j}$ de la colonne "j", le signal SET_ACT est mis à "0", le signal RST_ACT restant à "1". Le signal ACT passe donc à "0". Le transistor 138$_j$ est donc bloqué et le transistor 122 devient passant. En outre, le signal ENb$_j$ passe à "0". Le transistor 242j devient donc passant. Le signal EN_set_H$_j$ passe à "0". Le transistor 124$_j$ devient donc passant. Le signal EN_set_Hb$_j$ passe à "1" tandis que le signal EN_rst_Hb$_j$ reste à "0". La grille du transistor 130$_j$ reçoit le signal V$_{SET}$ et la grille du transistor 134$_j$ reçoit le signal V$_{Rj}$. Le circuit SA$_j$ fonctionne alors comme le circuit de détection de fin d'écriture 116 décrit précédemment en relation avec la figure 11.

Pour réaliser une opération d'effacement dans l'élément résistif R$_{i,j}$ de la colonne "j", le signal RST_ACT est mis à "0", le signal SET_ACT restant à "1". Le signal ACT passe donc à "0". Le transistor 138$_j$ est donc bloqué et le transistor 122 devient passant. En outre, le signal ENb$_j$ passe à "0". Le transistor 242$_j$ devient donc passant. Le signal EN_rst_H$_j$ passe à "0". Le transistor 124$_j$ devient donc passant. Le signal EN_rst_Hb$_j$ passe à "1" tandis que le signal EN_set_Hb$_j$ reste à "0". La grille du transistor 130$_j$ reçoit le signal V$_{Rj}$' et la grille du transistor 134$_j$ reçoit le signal V$_{RST}$. Le circuit SA$_j$ fonctionne alors comme le circuit de détection de fin d'effacement 154 décrit précédemment en relation avec la figure 12.

Des modes de réalisation particuliers ont été décrits. Diverses variantes et modifications apparaîtront à l'homme de l'art. En particulier, les transistors MOS à canal N peuvent être remplacés par des transistors MOS à canal P et les transistors MOS à canal P peuvent être remplacés par des transistors MOS à canal N en adaptant les signaux de commande de ces transistors.

En outre, bien que les modes de réalisation décrits précédemment concernent des cellules mémoires bipolaires pour lesquelles la polarité de la tension appliquée aux bornes de la cellule mémoire est inversée entre une opération d'écriture et une opération d'effacement, il est clair que ces modes de réalisation peuvent être adaptés à des cellules mémoires unipolaires pour lesquelles la polarité de la tension appliquée aux bornes de la cellule mémoire est la même pour une opération d'écriture et une opération d'effacement, seule la plage d'amplitude de la tension appliquée étant différente entre une opération d'écriture et une opération d'effacement.

En outre, bien que dans les modes de réalisation décrits précédemment en relation avec les figures 11 à 18, chaque cellule mémoire comprenne un élément résistif en série avec un interrupteur, notamment un transistor MOS, ces modes de réalisation peuvent être mis en oeuvre avec d'autres types de cellules mémoires. A titre d'exemple, chaque cellule mémoire peut comprendre une diode en série avec l'élément résistif.

**Revendications**

1. Mémoire résistive (5) comprenant des éléments résistifs (R$_{i,j}$) agencés en rangées et en colonnes, les colonnes étant réparties en groupes de colonnes, la résistance de chaque élément résistif pouvant alterner entre une valeur haute dans une première plage de valeurs et une valeur basse dans une deuxième plage de valeurs strictement inférieure à la valeur haute, **caractérisée en ce que** la mémoire comprend, en outre, un dispositif (14 ; 90) de basculement, pour chaque groupe, de la résistance d'au moins un élément résistif sélectionné parmi les éléments résistifs dudit groupe entre les valeurs haute et basse, le dispositif comprenant un premier circuit relié à toutes les colonnes, adapté à fournir une première rampe de tension croissante (VRamp), qui est une fonction croissant de façon linéaire en fonction du temps, et adapté à appliquer la première rampe de tension croissante aux bornes de chaque élément résistif sélectionné alors que l'élément résistif sélectionné est à la valeur haute ou à la valeur basse, le dispositif comprenant, pour chaque groupe, un deuxième circuit adapté à détecter le basculement de la résistance de l'élément résistif sélectionné dudit groupe, le dispositif comprenant en outre, pour chaque groupe, un troisième circuit adapté à interrompre le courant traversant l'élément résistif sélectionné dudit groupe à la détection du basculement, et le dispositif (14 ; 90) comprenant un quatrième circuit (32) configuré à recevoir la première rampe de tension croissante (VRamp) et à fournir une deuxième rampe de tension (Vref) croissante inférieure à la première rampe de tension croissante (VRamp), qui est une fonction croissant de façon linéaire en fonction du temps, le deuxième circuit étant adapté à comparer la deuxième rampe de tension croissante avec une tension (Vrm ; Vrm') qui varie en fonction de la résistance de l'élément résistif sélectionné.

**2.** Mémoire résistive selon la revendication 1, dans laquelle la tension (Vrm ; Vrm') est proportionnelle à la deuxième rampe de tension croissante avec un facteur de proportionnalité qui varie en fonction de la résistance de l'élément résistif sélectionné.

**3.** Mémoire résistive selon la revendication 1 ou 2, dans laquelle le deuxième circuit est adapté à détecter que la différence entre la deuxième rampe de tension croissante (Vref) et la tension (Vrm ; Vrm') change de signe.

**4.** Mémoire résistive selon l'une quelconque des revendications 1 à 3, comprenant un cinquième circuit (30) de fourniture d'une troisième rampe de tension (VRamp) croissante et un diviseur de tension comprenant en série au moins un composant résistif (Rm ; 72 ; 78 ; 96) et l'élément résistif sélectionné, la troisième rampe de tension croissante étant appliquée entre les bornes du diviseur de tension, la tension (Vrm ; Vrm') étant mesurée à un noeud (C) du diviseur de tension entre le composant résistif et l'élément résistif sélectionné.

**5.** Mémoire résistive selon l'une quelconque des revendications 1 à 4, dans laquelle le quatrième circuit (32) comprend des éléments résistifs supplémentaires (76) montés en série et en parallèle.

**6.** Mémoire résistive selon l'une quelconque des revendications 1 à 5, dans laquelle le deuxième circuit comprend un comparateur (40 ; 100) recevant la deuxième rampe de tension croissante (Vref) et la tension (Vrm ; Vrm') et fournissant un signal binaire (G ; R) qui dépend du signe de la différence entre la deuxième rampe de tension croissante (Vref) et la tension.

**7.** Mémoire résistive selon les revendications 4 et 6, dans laquelle le diviseur de tension comprend, en outre, un interrupteur (38 ; 98) commandé par le signal binaire (G) ou un signal (G') dérivé du signal binaire.

**8.** Procédé de commande d'une mémoire résistive (5) comprenant des éléments résistifs ($R_{i,j}$) agencés en rangées et en colonnes, les colonnes étant réparties en groupes de colonnes, la résistance de chaque élément résistif pouvant alterner entre une valeur haute dans une première plage de valeurs et une valeur basse dans une deuxième plage de valeurs strictement inférieure à la valeur haute, **caractérisé en ce que** le procédé comprend les étapes suivantes, pour le basculement, pour chaque groupe, de la résistance d'au moins un élément résistif sélectionné parmi les éléments résistifs dudit groupe entre les valeurs haute et basse :

fournir une première rampe de tension croissante (VRamp), qui est une fonction croissant de façon linéaire en fonction du temps ;
appliquer à toutes les colonnes la première rampe de tension croissante aux bornes de chaque élément résistif sélectionné alors que l'élément résistif sélectionné est à la valeur haute ou à la valeur basse ;
détecter, pour chaque groupe, le basculement de la résistance de l'élément résistif sélectionné dudit groupe ;
interrompre, pour chaque groupe, le courant traversant l'élément résistif sélectionné dudit groupe à la détection du basculement ;
recevoir la première rampe de tension croissante (VRamp) et fournir une deuxième rampe de tension croissante (Vref) inférieure à la première rampe de tension croissante (VRamp), qui est une fonction croissant de façon linéaire en fonction du temps ; et
comparer la deuxième rampe de tension croissante avec une tension (Vrm ; Vrm') qui varie en fonction de la résistance de l'élément résistif sélectionné.

**9.** Procédé selon la revendication 8, dans lequel la tension (Vrm ; Vrm') est proportionnelle à la deuxième rampe de tension croissante avec un facteur de proportionnalité qui varie en fonction de la résistance de l'élément résistif sélectionné.

**10.** Procédé selon la revendication 8 ou 9, comprenant la détection que la différence entre la deuxième rampe de tension croissante (Vref) et la tension (Vrm ; Vrm') change de signe.

**Patentansprüche**

**1.** Resistive Speicher (5), aufweisend Widerstandselemente ($R_{i,\,j}$), die in Reihen und Spalten angeordnet sind, wobei die Spalten in Gruppen von Spalten eingeteilt sind, wobei der Widerstand jedes Widerstandselements in der Lage ist, zwischen einem hohen Wert in einem ersten Wertebereich und einem niedrigen Wert in einem zweiten Wertebereich, der kleiner als der hohe Wert ist, zu alternieren, **dadurch gekennzeichnet, dass** der Speicher ferner eine Vorrichtung (14; 90) aufweist um für jede Gruppe den Widerstand mindestens eines Widerstandselements, ausgewählt aus den Widerstandselementen der Gruppe, zwischen dem hohen und dem niedrigen Werten zu schalten, wobei die Vorrichtung eine erste Schaltung aufweist, die mit allen Spalten verbunden ist, die in der Lage ist, eine erste ansteigende Spannungsrampe zu liefern, die eine linear mit der Zeit zunehmende Funktion ist, und die in der Lage ist, die erste ansteigende Spannungsrampe über jedes ausgewählte Widerstandselement anzulegen, während das ausgewählte Widerstandselement einen hohen oder niedrigen Wert aufweist, wobei die Vorrichtung für jede Gruppe eine zweite Schaltung aufweist, die in der Lage ist, das Schalten des Widerstands des ausgewählten Widerstandselements der Gruppe zu detektieren, wobei die Vorrichtung ferner für jede Gruppe eine dritte Schaltung aufweist, die in der Lage ist, den durch das ausgewählte Widerstandselement der Gruppe fließenden Strom beim Detektieren des Schaltens zu unterbrechen, und wobei die Vorrichtung (14; 90) eine vierte Schaltung (32) aufweist, die in der Lage ist, die erste ansteigende Spannungsrampe (VRamp) zu empfangen und eine zweite ansteigende Spannungsrampe (Vref) zu liefern, die niedriger ist als die erste ansteigende Spannungsrampe (VRamp), die eine linear mit der Zeit zunehmende Funktion ist, wobei die zweite Schaltung in der Lage ist, die zweite ansteigende Spannungsrampe mit einer Spannung (Vrm; Vrm') zu vergleichen, die sich gemäß dem Widerstand des ausgewählten Widerstandselements ändert.

2. Resistive Speicher nach Anspruch 1, wobei die Spannung (Vrm; Vrm') proportional zur zweiten ansteigenden Spannungsrampe ist, und zwar mit einem Proportionalitätsfaktor, der gemäß dem Widerstand des ausgewählten Widerstandselements variiert.

3. Resistive Speicher nach Anspruch 1 oder 2, wobei die zweite Schaltung in der Lage ist, zu detektieren, dass die Differenz zwischen der zweiten ansteigenden Spannungsrampe (Vref) und der Spannung (Vrm; Vrm') das Vorzeichen ändert.

4. Resistive Speicher nach einem der Ansprüche 1 bis 3, aufweisend eine fünfte Schaltung (30) zum Zuführen einer dritten ansteigenden Spannungsrampe (Vramp) und einen Spannungsteiler, der in Reihe wenigstens eine Widerstandskomponente (Rm; 72; 78; 96) und das ausgewählte Widerstandselement aufweist, wobei die dritte ansteigende Spannungsrampe über den Spannungsteiler angelegt wird und die Spannung (Vrm; Vrm') an einem Knoten (C) des Spannungsteilers zwischen der Widerstandskomponente und dem ausgewählten Widerstandselement gemessen wird.

5. Resistive Speicher nach einem der Ansprüche 1 bis 4, wobei die vierte Schaltung (32) zusätzliche Widerstandselemente (76) aufweist, die in Reihe und parallel geschaltet sind.

6. Resistive Speicher nach einem der Ansprüche 1 bis 5, wobei die zweite Schaltung einen Komparator (40; 100) aufweist, der die zweite ansteigende Spannungsrampe (Vref) und die Spannung (Vrm; Vrm') empfängt und ein Binärsignal (G; R) vorsieht, das vom Vorzeichen der Differenz zwischen der zweiten ansteigenden Spannungsrampe (Vref) und der Spannung abhängt.

7. Resistive Speicher nach den Ansprüchen 4 und 6, wobei der Spannungsteiler ferner einen Schalter (38; 98) aufweist, der durch das Binärsignal (G) oder ein vom Binärsignal abgeleitetes Signal (G') gesteuert wird.

8. Verfahren zum Steuern eines Resistive Speichers (5), der Widerstandselemente ($R_{i, j}$) aufweist, die in Reihen und Spalten angeordnet sind, wobei die Spalten in Gruppen von Spalten eingeteilt sind, wobei der Widerstand jedes Widerstandselements in der Lage ist, zwischen einem hohen Wert in einem ersten Wertebereich und einem niedrigen Wert in einem zweiten Wertebereich, der kleiner als der hohe Wert ist, zu alternieren, **dadurch gekennzeichnet, dass** das Verfahren die folgenden Schritte aufweist: für jede Gruppe das Umschalten des Widerstands wenigstens eines Widerstandselements, ausgewählt aus den Widerstandselementen der Gruppe zwischen dem hohen und dem niedrigen Wert:

    Liefern einer ersten ansteigenden Spannungsrampe (VRamp), die eine mit der Zeit linear ansteigende Funktion ist;
    Anlegen, in allen Spalten, der ersten ansteigenden Spannungsrampe an jedes ausgewählte Widerstandselement, während sich das ausgewählte Widerstandselement im hohen oder niedrigen Wert befindet;
    Detektieren, für jede Gruppe, des Umschaltens des Widerstands des ausgewählten Widerstandselements der Gruppe;
    Unterbrechen, für jede Gruppe, des durch das ausgewählte Widerstandselement der Gruppe fließenden Stroms, und zwar beim Detektieren des Schaltens;

Empfangen der ersten ansteigenden Spannungsrampe (VRamp) und Liefern einer zweiten ansteigenden Spannungsrampe (Vref), die niedriger ist als die erste ansteigende Spannungsrampe (VRamp), die eine mit der Zeit linear ansteigende Funktion ist; und

Vergleichen der zweiten ansteigenden Spannungsrampe mit einer Spannung (Vrm; Vrm'), die entsprechend dem Widerstand des ausgewählten Widerstandelements variiert.

9. Verfahren nach Anspruch 8, wobei die Spannung (Vrm; Vrm') proportional zur zweiten ansteigenden Spannungsrampe ist, und zwar mit einem Proportionalitätsfaktor, der gemäß dem Widerstand des ausgewählten Widerstandselements variiert.

10. Verfahren nach Anspruch 8 oder 9, das das Detektieren, dass die Differenz zwischen der zweiten ansteigenden Spannungsrampe (Vref) und der Spannung (Vrm; Vrm') das Vorzeichen ändert, aufweist.

**Claims**

1. A resistive memory (5) comprising resistive elements ($R_{i,j}$) arranged in rows an in columns, the columns being distributed in groups of columns, the resistance of each resistive element being capable of alternating between a high value in a first range of values and a low value in a second range of values smaller than the high value, **characterized in that** the memory further comprises a device (14; 90) for switching, for each group, the resistance of at least one resistive element selected from among the resistive elements of said group between the high and low values, the device comprising a first circuit connected to all columns, capable of supplying a first increasing voltage ramp (Vramp), which is a function linearly increasing along time, and capable of applying the first increasing voltage ramp across each selected resistive element while the selected resistive element is at the high value or at the low value, the device comprising, for each group, a second circuit capable of detecting the switching of the resistance of the selected resistive element of said group, the device further comprising, for each group, a third circuit capable of interrupting the current flowing through the selected resistive element of said group on detection of the switching, and the device (14; 90) comprising a fourth circuit (32) capable of receiving the first increasing voltage ramp (VRamp) and of supplying a second increasing voltage ramp (Vref) inferior to the first increasing voltage ramp (VRamp), which is a function linearly increasing along time, the second circuit being capable of comparing the second increasing voltage ramp with a voltage (Vrm; Vrm') which varies according to the resistance of the selected resistive element.

2. The resistive memory of claim 1, wherein the voltage (Vrm; Vrm') is proportional to the second increasing voltage ramp with a proportionality factor which varies according to the resistance of the selected resistive element.

3. The resistive memory of claim 1 or 2, wherein the second circuit is capable of detecting that the difference between the second increasing voltage ramp (Vref) and the voltage (Vrm; Vrm') changes sign.

4. The resistive memory of any of claims 1 to 3, comprising a fifth circuit (30) for supplying a third increasing voltage ramp (Vramp) and a voltage divider comprising, in series, at least one resistive component (Rm; 72; 78; 96) and the selected resistive element, the third increasing voltage ramp being applied across the voltage divider, the voltage (Vrm; Vrm') being measured at a node (C) of the voltage divider between the resistive component and the selected resistive element.

5. The resistive memory of any of claims 1 to 4, wherein the fourth circuit (32) comprises additional resistive elements (76) assembled in series and in parallel.

6. The resistive memory of any of claims 1 to 5, wherein the second circuit comprises a comparator (40; 100) receiving the second increasing voltage ramp (Vref) and the voltage (Vrm; Vrm') and providing a binary signal (G; R) which depends on the sign of the difference between the second increasing voltage ramp (Vref) and the voltage.

7. The resistive memory of claims 4 and 6, wherein the voltage divider further comprises a switch (38; 98) controlled by the binary signal (G) or a signal (G') derived from the binary signal.

8. A method of controlling a resistive memory (5) comprising resistive elements ($R_{i,j}$) arranged in rows and in columns, the columns being distributed in groups of columns, the resistance of each resistive element being capable of alternating between a high value in a first range of values and a low value in a second range of values smaller than the high value, **characterized in that** the method comprises the following steps of, for the switching, for each group, of the resistance of at least one resistive element selected from among the resistive elements of said group between the high and low values:

supplying a first increasing voltage ramp (VRamp), which is a function linearly increasing along time;
applying to all columns the first increasing voltage ramp across each selected resistive element while the selected resistive element is in the high value or in the low value;
detecting, for each group, the switching of the resistance of the selected resistive element of said group;
interrupting, for each group, the current flowing through the selected resistive element of said group on detection of the switching;
receiving the first increasing voltage ramp (VRamp) and supplying a second increasing voltage ramp (Vref) inferior to the first increasing voltage ramp (VRamp), which is a function linearly increasing along time; and
comparing the second increasing voltage ramp with a voltage (Vrm; Vrm') which varies according to the resistance of the selected resistive element.

9.  The method of claim 8, wherein the voltage (Vrm; Vrm') is proportional to the second increasing voltage ramp with a proportionality factor which varies according to the resistance of the selected resistive element.

10. The method of claim 8 or 9, comprising detecting that the difference between the second increasing voltage ramp (Vref) and the voltage (Vrm; Vrm') changes sign.

Fig 1

Fig 2

Fig 3

Fig 4

Fig 5

Fig 6

**Fig 7**

**Fig 8**

**Fig 9**

Fig 10

Fig 11

Fig 12

Fig 13

Fig 14

Fig 15

Fig 16

Fig 17

Fig 18

## RÉFÉRENCES CITÉES DANS LA DESCRIPTION

**Documents brevets cités dans la description**

- US 2010103726 A
- US 2010271861 A
- US 2013235651 A
- US 2013250657 A